(19) Europäisches Patentamt
European Patent Office
Office européen des brevets

(11) **EP 2 114 045 B1**

(12) **FASCICULE DE BREVET EUROPEEN**

(45) Date de publication et mention
de la délivrance du brevet:
**24.01.2018 Bulletin 2018/04**

(51) Int Cl.:
***H04L 27/36*** *(2006.01)*   ***H03D 7/18*** *(2006.01)*
***H03C 3/40*** *(2006.01)*

(21) Numéro de dépôt: **09159169.3**

(22) Date de dépôt: **30.04.2009**

(54) **ANNULATION DES IMPERFECTIONS D'UN MODULATEUR**

BEHEBUNG DER UNVOLLKOMMENHEITEN EINES DEMODULATORS

CANCELLING OUT OF THE IMPERFECTIONS OF A MODULATOR

(84) Etats contractants désignés:
**AT BE BG CH CY CZ DE DK EE ES FI FR GB GR HR HU IE IS IT LI LT LU LV MC MK MT NL NO PL PT RO SE SI SK TR**

(30) Priorité: **30.04.2008 FR 0802418**

(43) Date de publication de la demande:
**04.11.2009 Bulletin 2009/45**

(73) Titulaire: **THALES**
**92400 Courbevoie (FR)**

(72) Inventeurs:
• **Passelaigue, Daniel**
**78580, Maule (FR)**
• **Veryeras, Alexandre**
**78180, Montigny-Le-Bretonneux (FR)**
• **Autrusson, Bernard**
**92290, CHATENAY MALABRY (FR)**

(74) Mandataire: **Lucas, Laurent Jacques et al**
**Marks & Clerk France**
**Conseils en Propriété Industrielle**
**Immeuble Visium**
**22, Avenue Aristide Briand**
**94117 Arcueil Cedex (FR)**

(56) Documents cités:
WO-A-01/08293        US-A1- 2004 136 470
US-A1- 2006 062 324

## Description

La présente invention concerne un procédé d'annulation des imperfections d'un signal analogique généré par un dispositif permettant de moduler un signal analogique à partir d'un signal numérique de modulation. Elle peut s'appliquer par exemple dans tous les domaines où un signal analogique doit être modulé numériquement, que ce soit en amplitude ou en phase, comme la génération de formes d'onde radar, l'instrumentation de test et de mesure ou encore les télécommunications.

Réaliser un générateur de forme d'onde arbitraire large bande, très agile, de résolution très fine et de qualité spectrale comparable à celle d'une source de fréquence fixe n'est pas sans poser de nombreuses difficultés. De manière classique, des formes d'onde peuvent être générées arbitrairement en transposant directement un signal de modulation calculé en bande de base autour d'une porteuse de fréquence fixe au moyen d'un modulateur vectoriel. Mais cette méthode ne permet pas d'obtenir des signaux de grande qualité spectrale, à cause de la non idéalité des composants analogiques qui introduisent des imperfections dans le signal analogique modulé, notamment la fuite porteuse. L'imprécision de la quadrature génère également une raie image parasite et les distorsions dues à l'insuffisance de linéarité génèrent également des raies d'intermode parasites. Il s'agit là de l'un des problèmes techniques que la présente invention se propose de résoudre.

Des solutions existantes proposent des dispositifs annexes permettant notamment de compenser en boucle ouverte la fuite porteuse, la raie image et les raies d'intermodes. Mais ces solutions ne permettent pas d'atteindre un niveau de qualité compatible des applications de type radar embarqué, même dans des conditions normales d'utilisation, notamment en raison de leur temps de réponse qui est prohibitif par rapport à l'évolution des perturbations. Il s'agit là encore de l'un des problèmes techniques que la présente invention se propose de résoudre.

Le brevet américain US 6 931 343 B2 propose une solution en boucle fermée pour compenser la fuite porteuse et annuler la raie image. Cette solution sera explicitée plus en détails par la suite. Mais elle ne permet notamment pas de compenser les raies d'intermode, sauf à limiter la puissance de modulation applicable. Il s'agit là encore de l'un des problèmes techniques que la présente invention se propose de résoudre.

La demande de brevet US 2006/0062324A1 intitulée "Distortion compensation quadrature modulator and radio transmitter" décrit un modulateur à compensation de la distorsion en quadrature. Mais d'une part, le dispositif décrit dans cette demande ne permet de moduler un signal et de corriger ses imperfections que dans une bande utile assez étroite, de l'ordre de 200MHz de largeur. Et d'autre part, le dispositif décrit dans cette demande ne permet pas de corriger les défauts induits par la non-linéarité des amplificateurs vidéo et du modulateur, ce phénomène s'amplifiant quand la largeur de bande utile augmente.

La demande de brevet US 2004/136470A1 intitulée "Uncorrelated adaptive predistorter" décrit, quant à elle, un dispositive permettant de compenser une distorsion d'intermodulation induite par un amplificateur lorsque ledit amplificateur ne fonctionne pas dans sa zone de fonctionnement linéaire. Ledit dispositif introduit au niveau de l'entrée de l'amplificateur une "pré-distorsion" adaptative et comporte une boucle de réaction apte à filtrer une raie d'intermodulation présente dans le signal amplifié, à analyser l'amplitude de ladite raie et à modifier le signal de pré-distorsion combiné au signal à amplifier avant son entrée dans l'amplificateur, de façon à ce que, compte tenu des distorsions engendrées par l'amplificateur, l'amplitude de la raie d'intermodulation considérée soit minimisée. De par sa structure le dispositif décrit dans ce document ne permet pas de traiter de manière simultanée ni toutes les distorsions d'intermodulation, ni d'autre types de signaux parasites qui n'apparaissent pas dans le cadre d'un simple dispositif amplificateur, tels que les raies images ou les fuites de porteuse.

L'invention a notamment pour but de pallier les inconvénients précités. A cet effet, l'invention a pour objet un procédé d'annulation des imperfections d'un signal analogique généré par un dispositif permettant de moduler un signal analogique à partir d'un signal numérique de modulation. Le dispositif comporte un générateur de forme d'onde et un récepteur de surveillance dans une boucle fermée d'asservissement, le récepteur de surveillance comportant des oscillateurs numériques. Le signal numérique de modulation est asservi sur le signal analogique de manière à annuler des composantes parasites présentes dans le signal analogique. Le procédé comporte une phase de synchronisation des oscillateurs numériques du recepteur de surveillance. Il comporte également une phase de synchronisation de la phase du générateur de forme d'onde et de la phase du récepteur de surveillance, de sorte à définir une matrice de passage entre un repère de mesure et un repère de modulation. Il comporte également une phase de mesure des composantes spectrales parasites dans le repère de mesure. Il comporte également une phase d'estimation des composantes spectrales parasites dans le repère de modulation.

Avantageusement, la phase de mesure des composantes spectrales parasites peut utiliser des filtres capables de discriminer les différentes composantes spectrales dans le signal analogique modulé, sans interférer avec les raies parasites générées par le dispositif utilisé pour réaliser la mesure.

Dans un mode de réalisation, les filtres mis en oeuvre peuvent combiner un plan de fréquences à des filtres à moyenne glissante, les filtres à moyenne glissante étant optimaux en bruit et ayant leurs zéros de transmission distribués de manière régulière dans le plan de fréquences, de sorte que les composantes parasites peuvent être placées sur les zéros de puissance.

Par exemple, les composantes parasites peuvent inclure une fuite porteuse et/ou une raie image et/ou des raies d'intermode d'ordre 2 et/ou des raies d'intermode d'ordre 3.

L'invention a encore pour principaux avantages qu'elle permet de réduire de plusieurs ordres de grandeur les amplitudes de la fuite porteuse, de la raie image et des principales raies créées par les non-linéarités d'un modulateur vectoriel. Elle permet ainsi la synthèse directe en radiofréquences de fréquences agiles très pures ou de signaux arbitraires très précis. Elle est notamment adaptée aux applications de type radar embarqué.

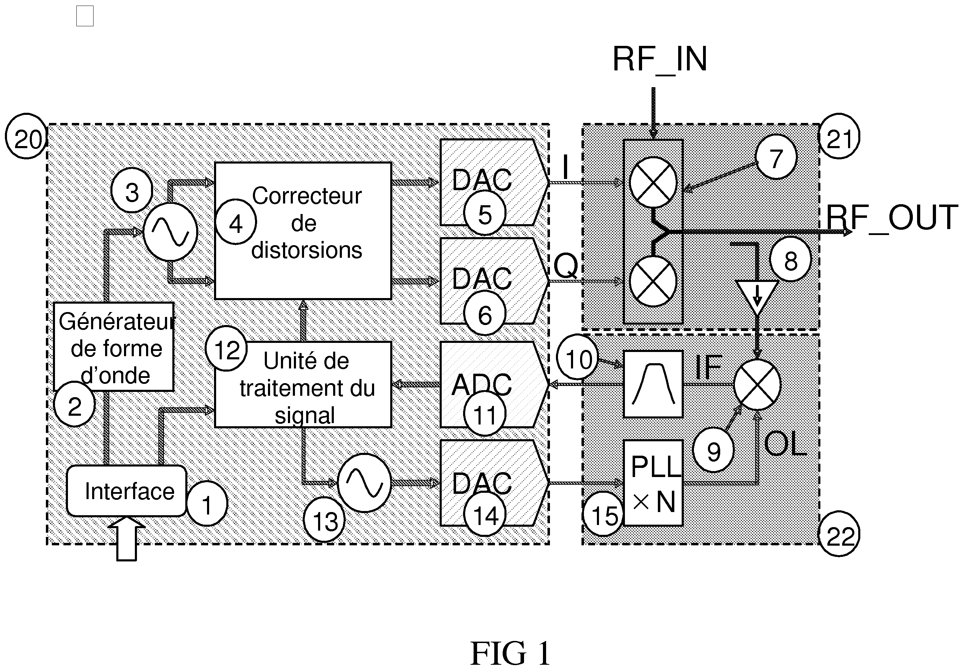

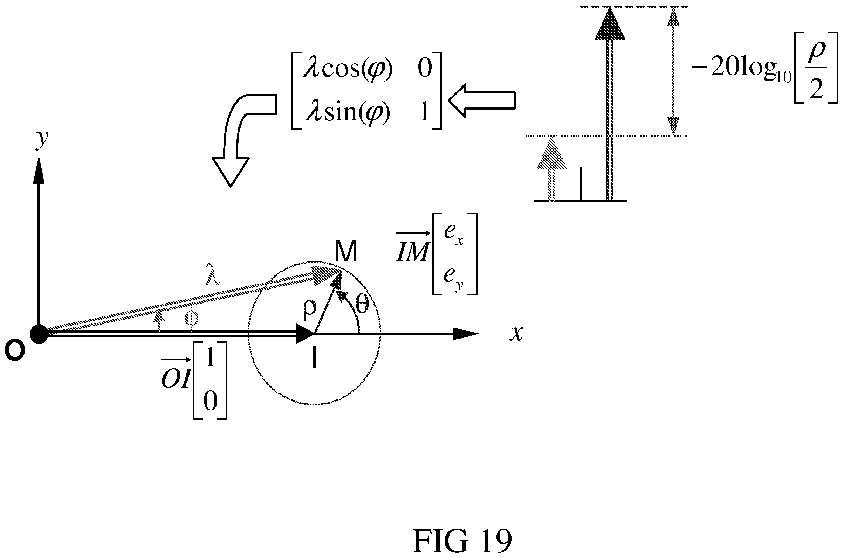

D'autres caractéristiques et avantages de l'invention apparaîtront à l'aide de la description qui suit faite en regard des figures 1 à 24 annexées.

La figure 1 illustre par un synoptique un exemple d'architecture matérielle implémentant un générateur de signaux arbitraires, selon une demande déposée antérieurement en France par la demanderesse sous le numéro 0801578. Les signaux arbitraires sont calculés en bande de base puis transposés directement sur une porteuse hyperfréquence par un modulateur vectoriel large bande. Ce type de générateur peut avantageusement être utilisé dans des applications de type radars embarqués. Il permet de moduler, avec une grande pureté spectrale, un signal analogique dans une large bande de fréquence à partir d'un signal numérique de modulation. En effet, il comporte des moyens pour surveiller et corriger en boucle fermée les imperfections de modulation, garantissant la qualité du signal généré même dans un environnement embarqué perturbé par des variations de températures rapides ou par des vibrations microphoniques, pour lesquelles les méthodes de compensation en boucle ouverte ne donnent pas satisfaction.

Le générateur comporte un synthétiseur 20 de signaux en bande de base formé par une interface de commande 1, un générateur de forme d'onde 2, un convertisseur polaire cartésien 3, un correcteur de distorsion 4, un convertisseur numérique-analogique (CNA) vidéo en phase 5, un CNA vidéo en quadrature 6, un CNA fréquence intermédiaire 11, une unité 12 de traitement du signal, un convertisseur polaire cartésien 13 et un CAN fréquence intermédiaire 14. Le synthétiseur 20 fournit deux signaux analogiques I et Q en quadrature à un modulateur vectoriel 21 formé par un modulateur vectoriel radio-fréquence (RF) 7 et des circuits de couplage 8. Le modulateur vectoriel 21 fournit en sortie un signal radiofréquence RF_OUT, en faisant une transposition vectorielle de fréquence autour d'une fréquence porteuse $F_0$ fournie par un signal radiofréquence RF_IN. Le signal RF_OUT est également transmis à un récepteur de surveillance 22, formé par un mélangeur descendant 9, un filtre anti-repliement 10 et un multiplicateur de fréquence 15 de type boucle à verrouillage de phase, couramment désignée par l'acronyme anglo-saxon « PLL » signifiant « Phase-Locked Loop ». Le récepteur 22 permet de mesurer le signal RF_OUT contenant les imperfections introduites par le modulateur vectoriel 21, à savoir notamment une fuite porteuse, une raie image et des raies d'intermode. Le récepteur 22 transmet la mesure à l'unité de traitement 12 via le CAN 11. Recevant également en entrée la modulation numérique théorique fournie par l'interface 1, l'unité 12 de traitement du signal peut corriger les imperfections dans RF_OUT, en implémentant des procédés de traitement du signal approprés. Le procédé selon la présente invention peut par exemple être mis en oeuvre dans l'unité de traitement 12 pour corriger en boucle fermée les imperfections introduites dans le signal RF_OUT par le modulateur vectoriel 21.

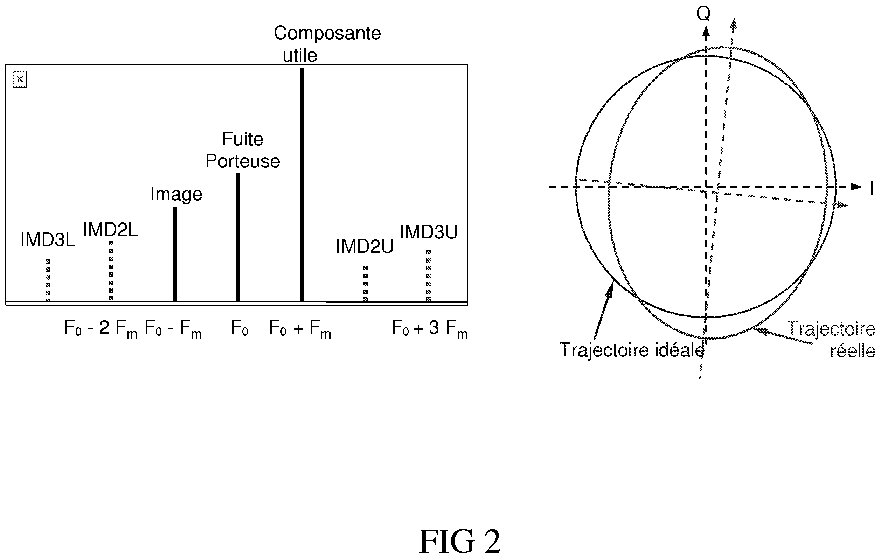

La figure 2 illustre par un diagramme de spectre et par un diagramme cartésien les imperfections introduites dans le signal RF_OUT par le modulateur vectoriel 21. Le diagramme de spectre illustre la répartition spectrale de la composante utile et des composantes parasites dans le signal RF_OUT. Le signal RF_OUT contient une composante utile se situant à une fréquence $F_0+F_m$ où $F_0$ est la fréquence porteuse d'oscillation fournie par le signal RF_IN et $F_m$ est une fréquence de modulation. Le signal RF_OUT contient également une fuite porteuse se situant à la fréquence $F_0$. Le signal RF_OUT contient également une raie image se situant à une fréquence $F_0-F_m$. Le signal RF_OUT contient également des raies d'intermode de rang 2, plus connues sous la désignation anglo-saxonne de « lower second-order intermodulation distortion » (IMD2L) et « upper second-order intermodulation distortion » (IMD2U), se situant respectivement à des fréquences $F_0-2F_m$ et $F_0+2F_m$. Le signal RF_OUT contient également des raies d'intermode de rang 3, plus connues sous la désignation anglo-saxonne de « lower third-order intermodulation distortion » (IMD3L) et « upper third-order intermodulation distortion » (IMD3U), se situant respectivement à des fréquences $F_0-3F_m$ et $F_0+3F_m$.

Les mêmes composantes parasites se retrouvent en sortie de tous les dispositifs de l'art antérieur utilisant un modulateur vectoriel pour moduler un signal analogique à partir d'un signal numérique. Pour compenser ces imperfections, l'art antérieur ne propose quasiment que des solutions classiques de compensation en boucle ouverte, difficilement transposables telles qu'elles au dispositif en boucle fermée de la figure 1. Dans ces solutions classiques en boucle ouverte, la fuite porteuse est compensée en ajoutant sur les entrées de modulation I et Q des tensions de polarisation qui génèrent un signal cohérent de la fuite, ces tensions étant ajustées jusqu'à obtenir l'annulation de la somme vectorielle de la fuite et du signal contrôlé. Dans ces solutions classiques en boucle ouverte, la raie image est compensée en exprimant la modulation dans un repère orthonormé parfait dans le repère physique de base (I, Q) du modulateur 21, comme illustré par le diagramme cartésien. Ainsi, la contribution de la raie image apparaît clairement sous la forme d'un décalage entre une trajectoire idéale définie par I et Q et une trajectoire réelle correspondant au signal RF_OUT mesuré en sortie du modulateur vectoriel 21. L'amplitude relative de la raie image est reliée à l'erreur d'amplitude et de phase par la formule suivante :

$$A_{dBc} \approx 10\, Log_{10} \left\{ \Delta A_{dB}^2 + \left( \frac{\Delta \phi_{\mathrm{deg}}}{6.6} \right)^2 \right\} - 24.8_{dB}$$

où $\Delta A_{dB}$ est l'erreur de gain en décibels (dB) et $\Delta \phi_{\mathrm{deg}}$ est l'erreur de phase en degrés. Contrôler la phase et le gain afin de compenser la variation en température, les effets microphoniques et la non-idéalité du modulateur 21 nécessite donc beaucoup de précision et synthétiser une modulation avec une qualité d'annulation de fuite porteuse et de raie image de l'ordre de 75 dBc dans une bande instantanée de 800 mégahertz (MHz) est un défi très difficile. En effet, une amplitude relative de la raie image par rapport au signal utile de -80 dBc correspond à un déséquilibre conjoint de 0.0012 dB en gain et de 0.008 degrés en phase. Par rapport à ce besoin, les tolérances des meilleurs circuits MMIC (« Microwave Monolithic Integrated Circuits ») sont typiquement de 0.1 dB et de 1 degré. Elles se traduisent par une dynamique sans parasites d'à peine 40 dBc ! Dans ces solutions classiques en boucle ouverte, les raies d'intermode d'ordre 2 et 3 ne sont pas compensées, alors que celles-ci génèrent des harmoniques qui se traduisent par la présence de raies parasites non négligeables. C'est pourquoi dans la pratique, pour obtenir la dynamique voulue sans introduire de parasites, il est courant de limiter la puissance de modulation applicable. Mais le bruit plancher est alors pénalisé. Il s'agit là encore de l'une des problème technique que la présente invention se propose de résoudre.

Les solutions classiques en boucle ouverte ne permettent donc pas d'atteindre un niveau de qualité compatible des applications de type radar embarqué, même dans des conditions normales d'utilisation. Ceci est également dû au temps de réponse des solutions en boucle ouverte, qui est prohibitif par rapport à l'évolution des perturbations. En effet, les objectifs de performance exigés par ces applications sont de deux ordres de grandeur plus sévères que les possibilités des circuits analogiques. Et plus la tolérance est étroite, plus il faut rafraîchir fréquemment les paramètres de compensation avant que les perturbations ne les fassent trop évoluer. Il faut donc travailler directement sur le signal utile, puisqu'il n'est plus possible à ce niveau de précision de procéder uniquement en boucle ouverte. Le niveau de performance visé impose d'intégrer le dispositif de mesure *in situ,* en boucle fermée, le modulateur 21 ne pouvant plus être dissocié de son circuit de commande ni de sa charge sans modifier les caractéristiques de la fuite et de la distorsion du fait des différences d'impédance, des faux zéros et des couplages involontaires. Une propriété remarquable de la modulation vectorielle est que toutes les distorsions présentes en sortie du modulateur 21 peuvent être corrigées en amont en utilisant les signaux de commande appropriés, dans une limite qui ne dépend que de la résolution de ces commandes et de la « durée de vie » de la correction.

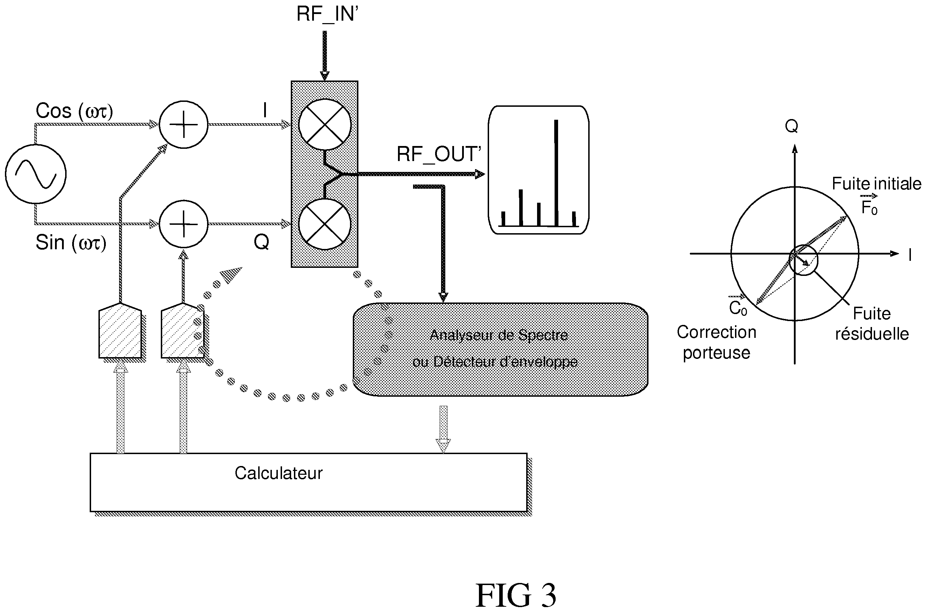

La figure 3 illustre par un synoptique une solution de compensation en boucle fermée connue dans l'art antérieur, telle que décrite dans le brevet américain US 6 931 343 B2. Ce brevet divulgue un générateur de forme d'onde utilisant un mélangeur à bande latérale unique 40 pour générer une modulation RF_OUT', qui sera appelé « mélangeur BLU 40 » par la suite, à partir d'un signal porteur RF_IN'. Le générateur comporte un mécanisme de correction en boucle fermée, le retour de boucle se faisant directement en sortie du mélangeur BLU 40 par l'intermédiaire d'un analyseur de spectre 42, d'un calculateur 43 et de deux CNA 44 et 45. Il s'agit de comparer l'amplitude instantanée du signal réel RF_OUT' avec ce qu'elle aurait dû être en des points particuliers de la constellation dans le plan cartésien associé au signal complexe, ceci afin d'estimer des paramètres de compensation à appliquer. Mais cette solution est essentiellement applicable à des applications de synthèse de signaux de télécommunication, elle est beaucoup moins adaptée à des applications de modulation de signaux radar.

En effet, les traitements qu'elle propose pour corriger la modulation sont fortement liés au dispositif de mesure mis en oeuvre. D'une part, un voltmètre vectoriel 41 donne le gain et la phase du signal en sortie du modulateur par rapport au signal incident. On peut à partir de ces mesures déterminer par analyse spectrale les composantes indésirables, la modulation étant simulée par une suite de tensions appliquées point par point sur les accès I et Q du mélangeur BLU 40 par un convertisseur polaire-cartésien 46. Mais cette méthode ne prend pas en compte les erreurs dynamiques, ce qui limite beaucoup son intérêt. D'autre part, l'analyseur de spectre 42 permet de mesurer l'amplitude des composantes indésirables dans une grande dynamique. L'annulation de la fuite porteuse et de la raie image peut être obtenue en modifiant itérativement les tensions de décalage I et Q et les corrections de quadrature jusqu'à extinction satisfaisante. Le brevet américain US 6 931 343 B2 divulgue d'utiliser un détecteur d'enveloppe comme l'analyseur 40 pour réaliser la fonction de surveillance. En effet, la détection logarithmique de l'enveloppe du signal modulé est le moyen de mesure le plus économique, puisqu'il n'y a pas d'oscillateur local à générer. Cependant, pour une bande d'agilité de plus de 200 MHz, cet avantage est moins évident car il est difficile d'analyser une bande vidéo large bande avec une bonne dynamique. Finalement, le générateur divulgué dans le brevet américain US 6 931 343 B2 permet seulement de corriger de façon préférentielle les défauts du mélangeur les plus gênants, à savoir la fuite porteuse et la raie image, ceci avec une faible dynamique et sur une bande de modulation étroite. Notamment, il ne permet pas de compenser les raies d'intermode. Il s'agit là encore de l'un des problème technique que la présente invention se propose de résoudre.

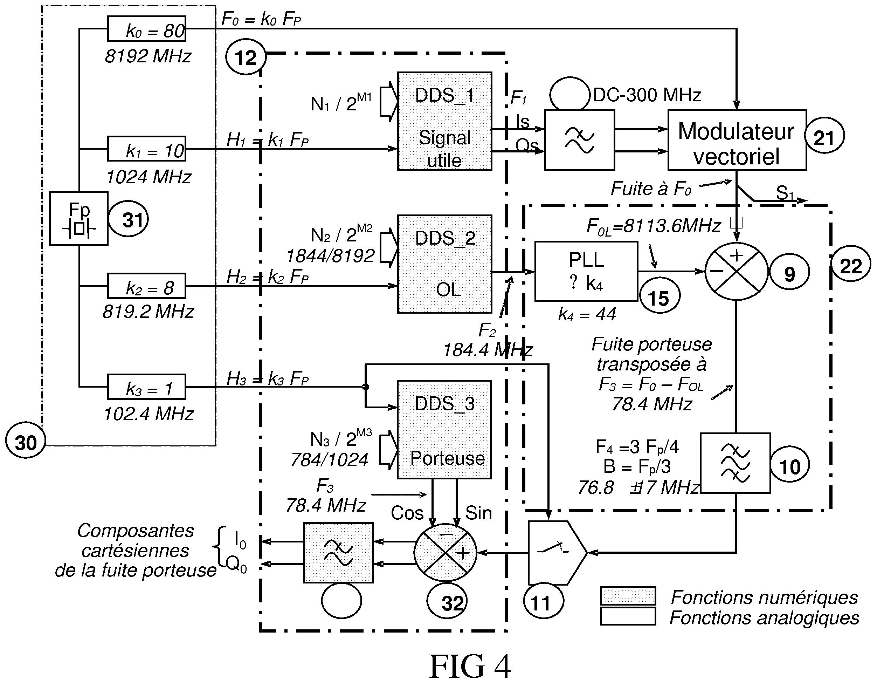

La figure 4 illustre par un synoptique un exemple d'architecture pouvant être mise en oeuvre dans l'unité 12 de traitement du signal pour compenser, selon la présente invention, les imperfections introduites dans le signal RF_OUT par le modulateur vectoriel 21. Cet exemple illustre le principe de la démodulation vectorielle pour un synthétiseur agile dans une bande instantanée utile de 600 MHz centrée sur une porteuse hyperfréquence de 8192 MHz. Un module 30 de génération de fréquences comporte un pilote à quartz 31 générant une fréquence pilote de référence $F_p$ à partir de laquelle sont générées les fréquences fixes nécessaires aux différents blocs analogiques et numériques. La porteuse hyperfréquence $F_0$ en entrée du modulateur vectoriel 21 est choisie telle que $F_0 = k_0 F_P$ où $k_0$ est un entier tel que $F_0$ est une puissance de 2 en mégahertz, ceci afin de simplifier les valeurs numériques exprimées en notation décimale. Dans le présent exemple, $F_0$=8192°MHz. Un signal d'horloge $H_1$=$k_1 F_P$ ,où $k_1$ est un entier, est fourni en entrée d'un module de synthèse numérique directe DDS_1 (« Direct Digital Synthesis ») permettant de générer le signal utile de composantes cartésiennes $I_S$ et $Q_S$ à une fréquence $F_1$, fourni en entrée d'un synthétiseur d'étalonnage 16. Un signal d'horloge $H_2$=$k_2 F_P$, où $k_2$ est un entier, est fourni en entrée d'un module de synthèse numérique directe DDS_2 permettant de générer l'oscillateur local (OL) de transposition en fréquence intermédiaire de la boucle de retour. Un signal d'horloge $H_3$=$k_3 F_P$, où $k_3$ est un entier, est fourni en entrée d'un module de synthèse numérique directe DDS_3 permettant de générer l'oscillateur de démodulation numérique en bande de base et d'échantillonnage du CAN 11 de mesure. Toutes ces fréquences peuvent être élaborées de diverses manières, de préférence par division de fréquence ou multiplication indirecte de fréquence, de manière à optimiser le bruit de phase. L'important est qu'elles soient liées entre elles par des rapports de la forme p/q avec p et q entiers, pour permettre une démodulation cohérente sans glissement de phase. Le récepteur de surveillance 22 comporte la PLL 15, le mélangeur 9 qui est équilibré et le filtre anti-repliement 10. Le récepteur 22 permet de générer une fréquence locale d'oscillation $F_{OL}$, en multipliant dans la PLL 15 un signal à la fréquence $F_2$ fourni en sortie du module DDS_2 par un entier $k_4$. Le convertisseur analogique numérique 11 a une résolution typique de l'ordre de 14 à 16 bits. Un démodulateur numérique en quadrature 32 est piloté par un signal à la fréquence $F_3$ généré à la sortie du module DDS_3. Il faut comprendre que l'exemple d'architecture de base illustré par la figure 4 peut se décliner suivant diverses variantes sans déroger aux principes de la présente invention.

Cependant, les variantes d'implémentation de la présente invention ont des caractéristiques en commun. Première caractéristique en commun, celle de permettre une mesure vectorielle précise de la composante spectrale utile et des composantes spectrales parasites, ceci en vue de permettre la compensation des composantes spectrales parasites. Ceci implique de maintenir pendant toute la durée d'utilisation la cohérence de phase entre le récepteur de surveillance 22 et le générateur de forme d'onde 2, afin de déterminer une fois pour toutes la matrice de passage entre le repère de mesure et le repère de modulation, c'est-à-dire les valeurs I et Q estimées de la fuite porteuse. La matrice de passage est étalonnée au départ par application d'un décalage arbitraire sur la composante I puis sur la composante Q. Les oscillateurs numériques qui constituent le dispositif de surveillance, à savoir le module DDS_2 qui génère la fréquence auxiliaire d'étalonnage et le module DDS_3 qui génère l'oscillateur numérique de démodulation du récepteur, sont coordonnés de manière à conserver le repère de référence ainsi défini. Pour modifier leur fréquence sans perdre la mémoire de phase, plusieurs intégrateurs de phase combinés entre eux sont utilisés. Un exemple plus détaillé est explicité par la suite. La compensation peut avoir lieu pendant une séquence d'étalonnage ou en cours d'utilisation pour maintenir les performances. Par exemple, la bande passante du synthétiseur 20 peut être étendue au-delà des possibilités de la génération en bande de base, en commutant $F_0$ sur un peigne de fréquences fixes. Un ensemble de codeurs entrelacés peuvent également se substituer au modulateur vectoriel 21. Plusieurs synthétiseurs dont les bandes sont décalées en fréquence peuvent aussi être combinés.

Par ailleurs, les variantes d'implémentation de la présente invention ont également en commun de mettre en oeuvre des filtres particuliers, capables de discriminer les différentes composantes spectrales entre elles sans interférer avec les raies parasites générées par le système de mesure lui-même, qui a ses propres défauts. Ceci est réalisé en combinant un plan de fréquences particulier à des filtres à moyenne glissante. Ces filtres ont la propriété d'être optimaux en bruit et en même temps de disposer de zéros de transmissions régulièrement distribués, sur lesquels les composantes indésirables peuvent être placées judicieusement. Un exemple de réalisation est est explicité ci-dessous en détails.

### Annulation de la fuite porteuse

### *Choix des fréquences*

Les fréquences $H_2$ et $F_2$ sont déterminées par les rangs de multiplication $k_2$ et $k_3$. La fréquence $F_2$ est choisie proche de 9/40 × $H_2$ pour se placer dans un domaine dégagé des parasites de synthèse les plus forts, c'est-à- entre $H_2$/4 et $H_2$/5. La fréquence $F_3$ associée à la fuite porteuse est choisie au voisinage d'un multiple impair de $F_P$/4.

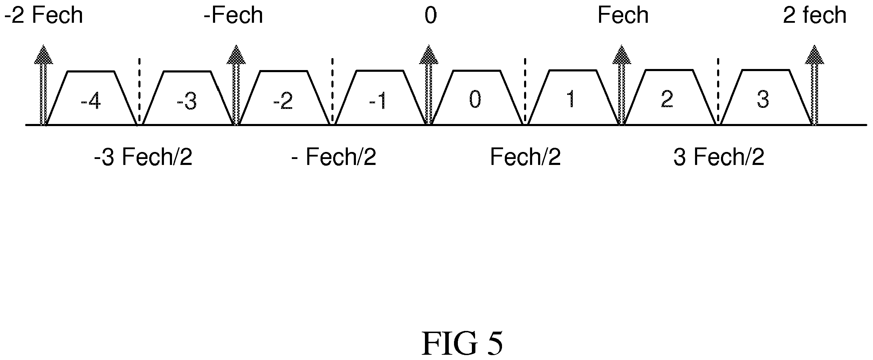

Comme illustré par la figure 5, la bande utile du récepteur numérique est possible dans différentes fenêtres ambiguës appelées « alias ». Le coefficient p définit l'« alias » dans lequel nous choisissons la fréquence intermédiaire. Ceci se traduit par les relations :

$$\begin{cases} F_0 = k_0 F_P \\ F_{OL} \cong \dfrac{9\,k_2 k_4}{40} F_P \end{cases} \quad F_3 = F_0 - F_{OL} \cong (2p+1)\dfrac{F_P}{4} \quad \Leftrightarrow \quad k_2 k_4 \cong \dfrac{40\,k_0 - 10 \times (2p+1)}{9}$$

Dans l'exemple choisi, $k_0 = 80$, cette condition s'écrit donc :

$$k_2 k_4 \cong \frac{3200 - 10 \times (2p+1)}{9}$$

Parmi les combinaisons ($k_2$, $k_4$) possibles, les rangs pairs sont plus intéressants parce que le facteur de forme d'un diviseur de fréquence de rang pair est symétrique et qu'ils sont plus faciles à réaliser aux fréquences élevées. Nous ne testons donc que les valeurs paires de $k_2$. Nous restreignons la recherche de solutions à p = -2 ou +1. Dans les alias p = 0 et p = -1 les harmoniques du signal en fréquence intermédiaire peuvent être dans la bande utile et pour les alias de rang élevé p > 2 ou p < -3 le bruit plancher provoqué par la gigue de l'horloge d'échantillonnage en présence d'un signal gêneur puissant, se dégrade proportionnellement à la fréquence. Nous limitons la valeur de $k_2$ à 10 pour des considérations technologiques de vitesse. Ceci conduit au tableau des combinaisons intéressantes ci-dessous :

| Alias p | $k_2$ | $k_4$ | $k_2 \times k_4$ | $k_2 \times k_4$ th | Ecart | Rang |
|---------|-------|-------|------------------|---------------------|-------|------|
| -2 | 2 | 179 | 358 | 358,89 | 0,89 | 4 |
| -2 | 4 | 90 | 360 | 358,89 | 1,11 | 5 |
| -2 | 6 | 60 | 360 | 358,89 | 1,11 | 5 |
| -2 | 8 | 45 | 360 | 358,89 | 1,11 | 5 |
| -2 | 10 | 36 | 360 | 358,89 | 1,11 | 5 |
| 1 | 2 | 176 | 352 | 352,22 | 0,22 | 1 |
| 1 | 4 | 88 | 352 | 352,22 | 0,22 | 1 |
| 1 | 6 | 59 | 354 | 352,22 | 1,78 | 9 |
| 1 | 8 | 44 | 352 | 352,22 | 0,22 | 1 |
| 1 | 10 | 35 | 350 | 352,22 | 2,22 | 10 |

Nous retenons finalement le couple de deux valeurs paires $k_2 = 8$, $k_4 = 44$ pour ce synthétiseur. Une fois les rangs $k_2$, $k_4$ et p fixés, il faut déterminer *a posteriori* la commande précise du DDS_2 pour placer la fréquence $F_3$ associée à la fuite porteuse approximativement au centre du filtre anti-repliement 10. Si $M_2$ est le nombre de bits utilisé par le synthétiseur d'étalonnage 16 et $N_2$ le code binaire de la fréquence $F_2$, nous avons :

$$F_0 = k_0 F_P; \quad F_2 = \frac{N_2}{2^{M_2}} \times k_2 F_P; \quad F_{OL} = F_2 \times k_4 F_P; \quad F_3 = F_0 - F_{OL}; \quad F_4 = \frac{2p+1}{4} F_P;$$

$$F_3 \approx F_4 \Rightarrow \quad N_2 = Arr\left\{ \left( k_0 + \frac{2p+1}{4} \right) \times \frac{2^{M2}}{k_2 k_4} \right\}$$

Pour $k_0 = 80$, $k_2 = 8$, $k_4 = 44$, $p = 1$, on trouve la valeur :

$$N_2 = Arrondi\left[ \left( 80 - \frac{3}{4} \right) \times \frac{8192}{8 \times 44} \right] = 1844$$

Le jeu des fréquences obtenues est donc finalement :

$$H_2 = 8 \times 102.4 = 819.2 \; MHz \qquad\qquad F_{OL} = 44 \times 184.4 = 8113.6 \; MHz$$

$$F_2 = \frac{1844}{8192} \times 819.2 = 184.4 \; MHz \qquad\qquad F_3 = 8192 - 8113.6 = 76.4 \; MHz$$

**Synthèse de $F_3$**

La fréquence du synthétiseur DDS_3 doit être rigoureusement identique à celle de la fuite porteuse, modulo la fréquence d'échantillonnage, de manière à ce qu'il n'y ait aucun décalage de phase d'une mesure à l'autre. Pour cela, il faut respecter la relation :

$$F_3 = \frac{N_3}{2^{M3}} \times F_P = \left( k_0 - \frac{k_2 k_4 N_2}{2^{M2}} \right) \times F_P$$

Ce qui ne pose pas de problème particulier lorsque $k_2$ et $k_4$ sont entiers, il suffit de consacrer autant de bits à la synthèse de $F_3$ qu'à celle de $F_2$ pour obtenir une solution simple. Pour cet exemple nous trouvons :

$$F_3 = \left( \frac{80 \times 8192 - 8 \times 44 \times 1844}{8192} \right) Fp = \frac{49}{64} \times Fp$$

Il est parfois intéressant de choisir des rapports rationnels (p/q) plutôt qu'entiers. Dans ce cas les choses se compliquent car il n'y a pas de solution entière sur une base binaire. On peut heureusement synthétiser une commande de fréquence fractionnaire en ajoutant ou retranchant périodiquement le résidu de phase approprié pour compenser l'avance ou le retard dû à la partie fractionnaire. Par exemple pour synthétiser la fréquence $\frac{23}{30} F_P$ proche de $\frac{49}{64} F_P$ mais fractionnaire en base 2, on écrit la fraction rationnelle sous la forme suivante :

$$\frac{23}{30} = \frac{23 \times 64}{30 \times 64} = \frac{\left( \frac{23 \times 32}{15} \right)}{64} = \frac{\left( 49 + \frac{1}{15} \right)}{64}$$

En programmant la valeur $\frac{49}{64}$ et en ajoutant un incrément de phase supplémentaire une fois sur 15 on obtient exactement la fréquence souhaitée, c'est un principe similaire à celui des pré-diviseurs à deux modules (p /p+1).

**Relation entre vitesse de mesure et dynamique**

Le principal facteur qui limite la bande passante possible de l'asservissement pour compenser la fuite porteuse et les autres raies parasites dans une dynamique donnée est le rapport signal sur bruit. Plus la dynamique à corriger est importante et plus il faut intégrer longtemps et comme cela impacte directement le retard pur de la boucle de rétroaction, la bande passante doit être diminuée. Le bilan typique de la chaîne de surveillance est illustré par le tableau suivant :

| Hypothèses | |
|---|---|
| Pmax BLU | -12,0 dBm |
| NF récepteur | 12,0 dB |
| Psat du codeur | +7,5 dBm |
| Fech codeur | 102,4 MHz |

(suite)

| Hypothèses | |
|---|---|
| S/B min | 15,0 dB |
| SNR du codeur | 75,0 dB |
| Marge avant saturation | 1,0 dB |
| Durée d'intégration | 5,6 $\mu$s |

| Conséquences | |
|---|---|
| Gain optimal | 18,5 dB |
| kT | -174,0 dBm |
| bruit RF | -143,5 dBm/Hz |
| bruit codeur | -144,6 dBm/Hz |
| bruit global | -141,0 dBm/Hz |
| Taux de décimation | 573 pts |
| Bande d'analyse | 178,71 kHz |
| Pmin | -73,5 dBm |
| Pmax | +6,5 dBm |
| **Dynamique** | **80,0 dB** |

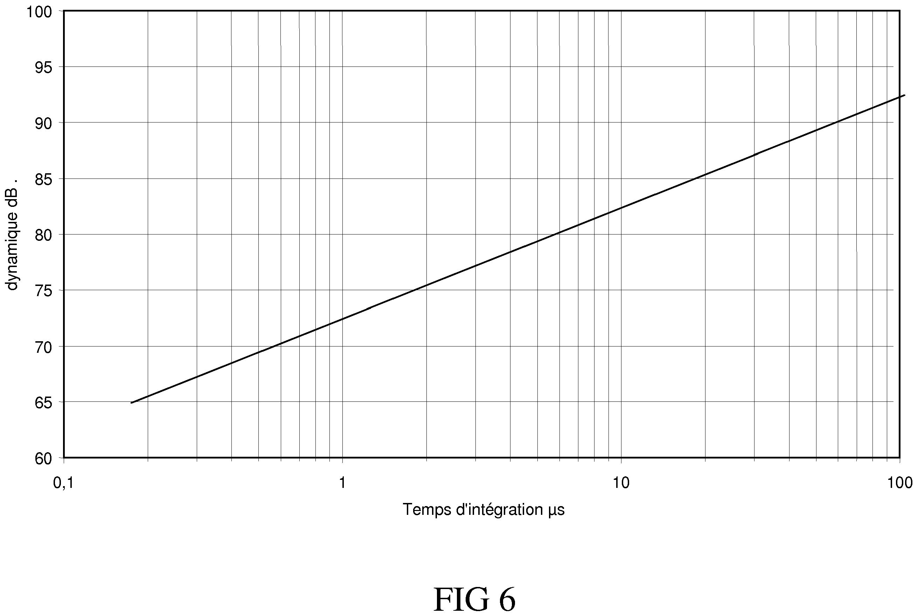

La figure 6 illustre l'évolution de la dynamique en décibels en fonction du temps d'intégration. Ce bilan typique montre qu'il faut disposer d'un temps de mesure d'au moins 5,6 microsecondes ($\mu$s) pour pouvoir compenser la fuite dans une dynamique de 80 dB, avec comme hypothèse de travailler avec une marge de 15 dB pour corriger le modulateur sans en dégrader le bruit. On se rend compte aussi que pour réduire le temps d'intégration d'un facteur 10 il faut sacrifier 10 dB sur la dynamique de correction. Il existe donc une sorte de principe d'incertitude qui fixe une limite pratique entre la bande passante des perturbations et la dynamique sans parasites que l'on souhaite obtenir. Il est intéressant d'évaluer aussi la contribution du codeur analogique numérique sur la dynamique que l'on peut corriger, toutes choses égales par ailleurs.

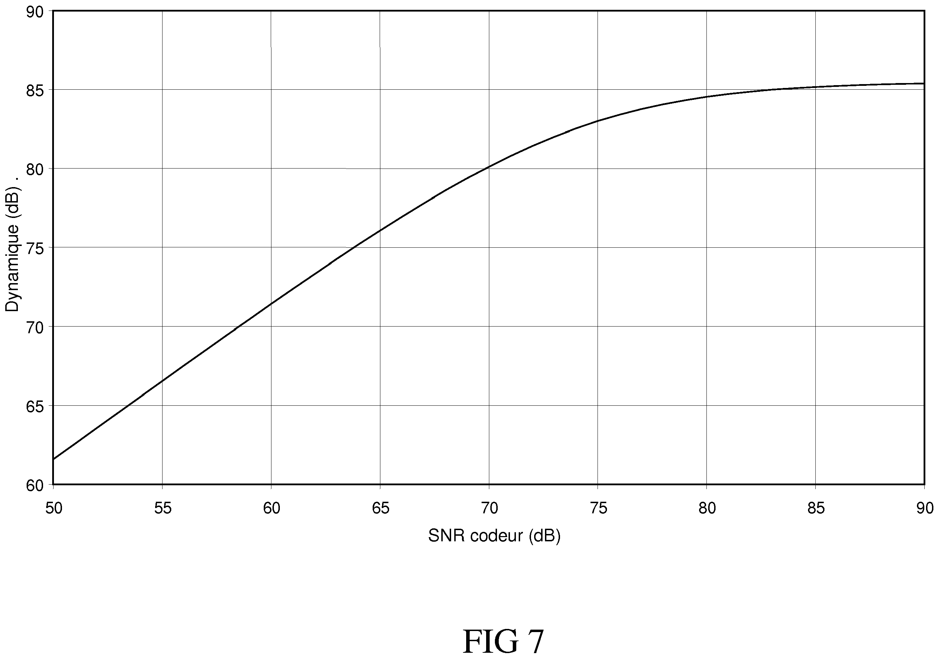

La figure 7 illustre l'évolution de la dynamique en décibels en fonction des performances du codeur en matière de rapport signal sur bruit en décibels, rapport plus connu sous l'acronyme anglo-saxon « SNR » signifiant « Signal-to-Noise Ratio ». Cette courbe, établie ici pour un temps d'intégration de 5,6 $\mu$s, montre que la dynamique plafonne à environ 85 dB pour des codeurs dont les performances de SNR seraient meilleures que 75 dB, performance associée typiquement à des codeurs de 15 ou 16 bits. Il va de soi que la dynamique sans parasites doit être en rapport avec la durée du signal généré, parce que la sensibilité d'une analyse spectrale est proportionnelle à la durée d'analyse.

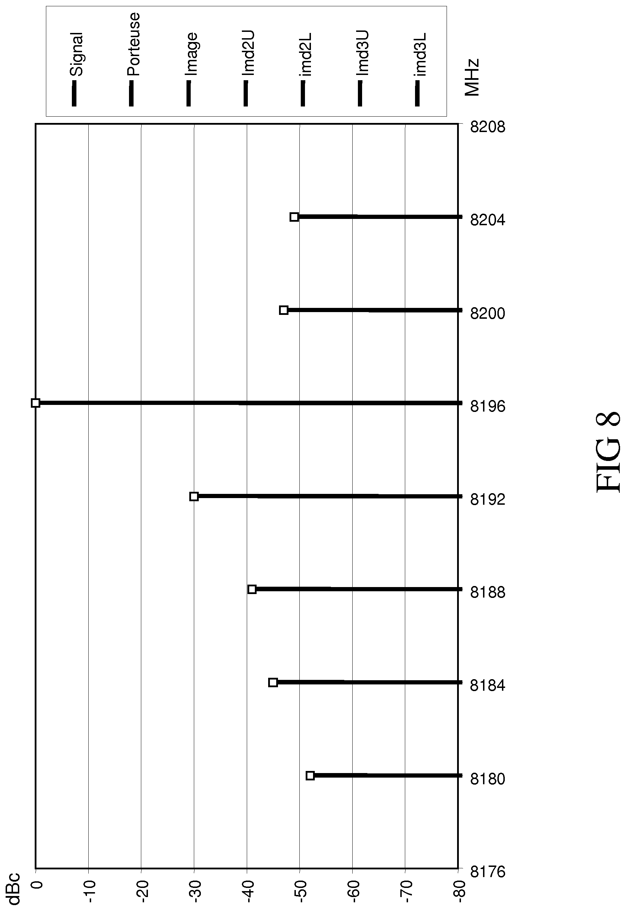

Dans le cas d'une modulation basse fréquence, comme illustré par l'exemple de la figure 8, lorsque la modulation appliquée est purement sinusoïdale, le spectre RF brut typique en sortie du modulateur 21 comprend :

- la raie représentative du signal utile à $F_0 + F_1$,
- la fuite porteuse à $F_0$,
- la raie image à $F_0 - F_1$,
- deux raies latérales d'inter modulation d'ordre 2 à $F_0 + 2F_1$ et $F_0 - 2F_1$,
- deux raies latérales d'inter modulation d'ordre 3 à $F_0 + 3F_1$ et $F_0 - 3F_1$.

Ce spectre peut être très resserré, le temps de mesure doit au minimum être d'une période de la modulation pour permettre de séparer les différentes composantes qui le constituent.

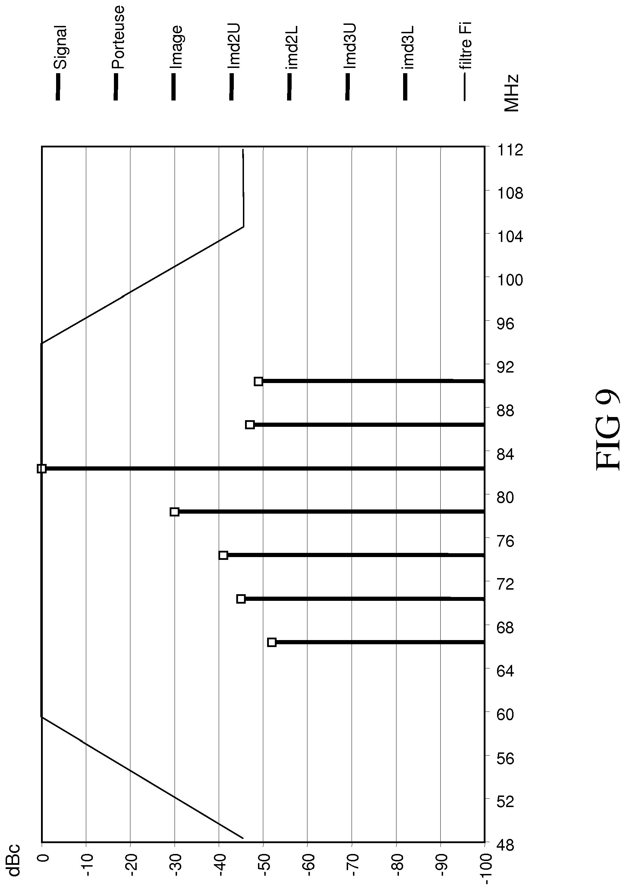

La figure 9 illustre un autre exemple de spectre RF. Lorsque la fréquence de modulation est inférieure à quelques 5 MHz, le spectre RF du modulateur est intégralement transposé dans la bande utile du filtre anti-repliement, le filtre numérique doit supporter toute la dynamique.

Un signal pur réel se décompose en deux composantes de fréquences opposées, données par les deux relations suivantes :

$$\cos(\omega t) = \frac{\exp(j\omega t) + \exp(-j\omega t)}{2}$$

$$\sin(\omega t) = \frac{\exp(j\omega t) - \exp(-j\omega t)}{2j}$$

Le signal numérisé en bande de base comprend donc 14 composantes spectrales symétriques deux à deux données dans le tableau suivante :

| Composante | Fréquence + | MHz | Fréquence - | MHz | dBc |
|---|---|---|---|---|---|
| Porteuse | $F_3$ | 78,4 | $F_P - F_3$ | 24 | -45 |
| Signal | $F_3 + F_1$ | 82,4 | $F_P - F_3 - F_1$ | 20 | 0 |
| Image | $F_3 - F_1$ | 74,4 | $F_P - F_3 + F_1$ | 28 | -38 |
| Imd2U | $F_3 + 2 F_1$ | 86,4 | $F_P - F_3 - 2 F_1$ | 16 | -58 |
| imd2L | $F_3 - 2 F_1$ | 70,4 | $F_P - F_3 + 2 F_1$ | 32 | -59 |
| Imd3U | $F_3 + 3 F_1$ | 90,4 | $F_P - F_3 - 3 F_1$ | 12 | -55 |
| imd3L | $F_3 - 3 F_1$ | 66,4 | $F_P - F_3 + 3 F_1$ | 36 | -58 |

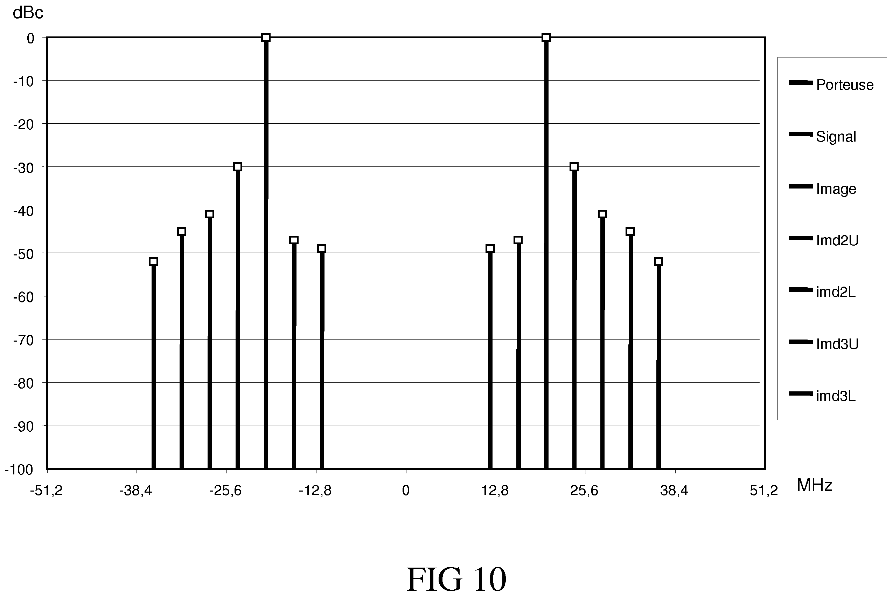

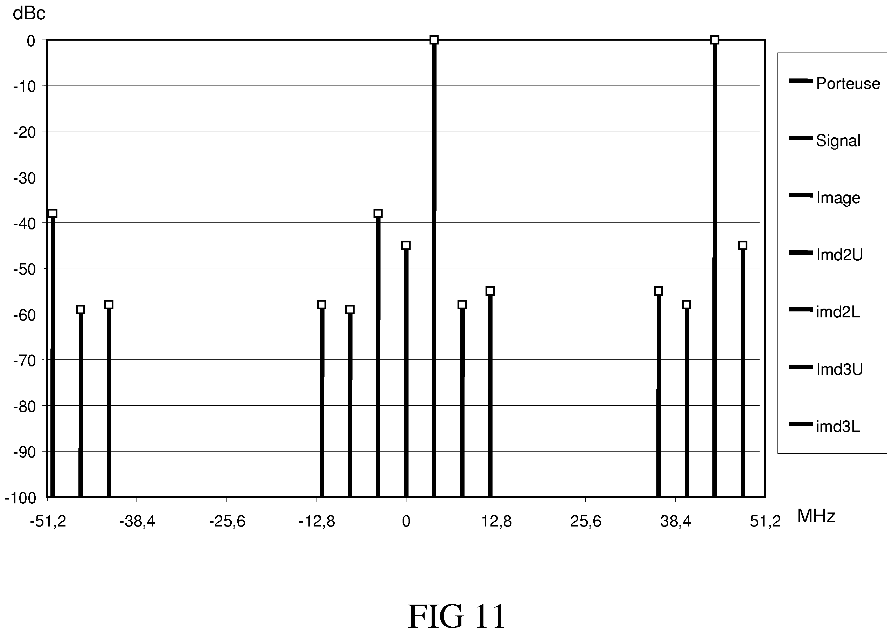

La figure 10 illustre le spectre du signal numérisé en bande de base, dans le cas où $F_1$=4°MHz, $F_{OL}$=8113,6°MHz, $F_{ech}$=102,4°MHz, $N_{avg}$=1 et $F_3$=0. Comme illustré par la figure 11, une transposition du spectre brut applique un décalage circulaire de fréquence ($-F_3$) qui ramène la fuite porteuse à zéro. Ceci donne le jeu de fréquences du tableau suivant :

| Composante | Fréquence + | MHz | Fréquence - | MHz | dBc |
|---|---|---|---|---|---|
| Porteuse | 0 | 0 | $2 F_P - 2 F_3$ | 48 | -45 |
| Signal | $F_1$ | 4 | $2 F_P - 2 F_3 - F_1$ | 44 | 0 |
| Image | $- F_1$ | -4 | $2 F_P - 2 F_3 + F_1$ | -50,4 | -38 |
| Imd2U | $2 F_1$ | 8 | $2 F_P - 2 F_3 - 2 F_1$ | 40 | -58 |
| imd2L | $2 F_1$ | -8 | $2 F_P - 2 F_3 + 2 F_1$ | -46,4 | -59 |
| Imd3U | $3 F_1$ | 12 | $2 F_P - 2 F_3 - 3 F_1$ | 36 | -55 |
| imd3L | $- 3 F_1$ | -12 | $2 F_P - 2 F_3 + 3 F_1$ | -42,4 | -58 |

### Filtrage numérique optimum

Le filtre numérique le plus efficace en termes de rapport signal sur bruit pour mesurer la composante continue d'un signal est la moyenne. D'autres filtres sont possibles mais la moyenne a des propriétés très intéressantes ici. La fonction de transfert d'un filtre à moyenne de N points est donnée par l'expression :

$$H(x) = e^{-i(N-1)x} \ \frac{\sin(N x)}{N \sin(x)} \quad avec \quad x = \pi \frac{f}{fech}$$

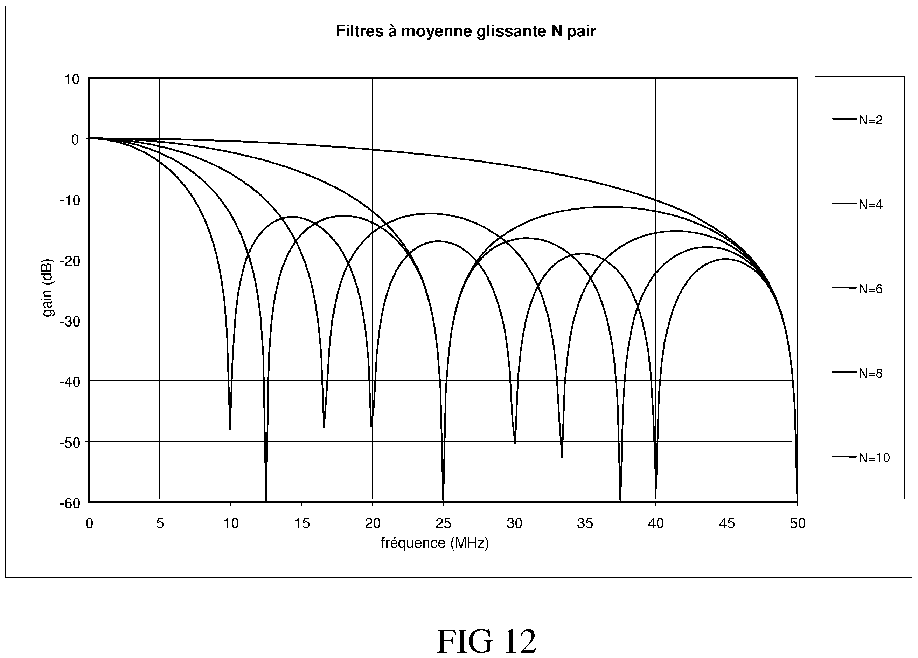

La figure 12 illustre les fonctions de transfert de la moyenne glissante en décibels, pour N pair.

La durée d'intégration doit être choisie égale à un nombre entier de périodes des composantes spectrales gênantes. Dans l'exemple cité, nous devons éliminer 13 fréquences : -4, 4, -8, 8, -12, 12, 36, 44, 48, 42.4 ($\equiv$ 60), -46.4 ($\equiv$ 56), -50.4 ($\equiv$ 52) MHz modulo 102.4 MHz. Le Plus Grand Commun Diviseur (PGCD) de la fréquence de modulation $F_1$ = 4 MHz et de la fréquence d'échantillonnage $F_P$ = 102.4 MHz est $\Delta f$ = 102.4/128 = 4/5 = 0.8 MHz. Les fréquences indésirables sont toutes des multiples (modulo $F_P$) de la fréquence de modulation $F_3$ = 4 MHz, *a fortiori* multiple du PGCD $\Delta f$. Elles sont donc éliminées par un filtre à moyenne glissante multiple de $N_{AVG}$ = $F_P$ / PGCD($F_1$,$F_P$), ce qui donne $N_{AVG}$ = 128 points dans le présent exemple. Cette propriété remarquable n'est vérifiée que parce que la fréquence $F_3$ a été judicieusement calée sur un multiple de $\Delta f$ /2, soit $F_3$ = 76.4 MHz = 382 $\times$ 0.4/2 MHz = 382 $\Delta f$/2. Pour étalonner toutes les fréquences au pas de 1 MHz, il faut intégrer 4 fois plus, soit 512 =points.

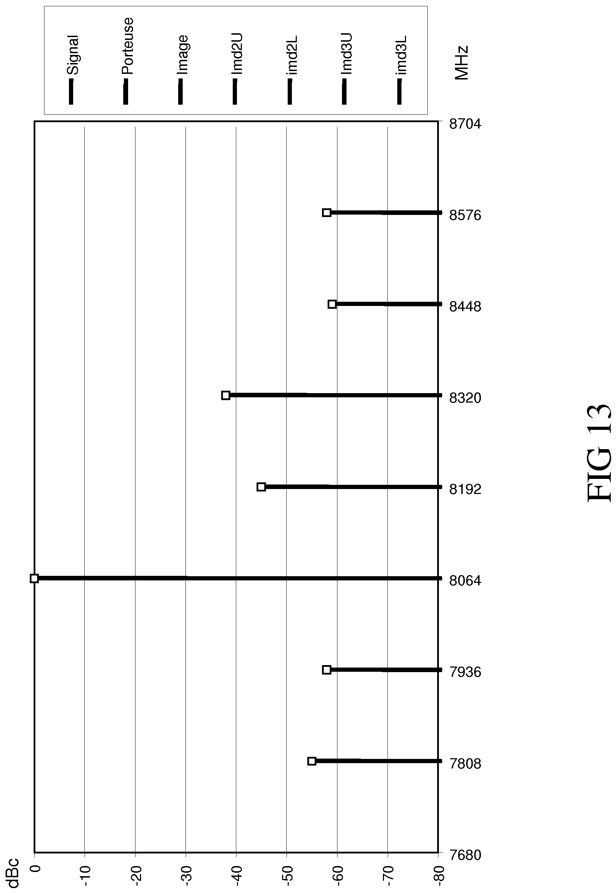

Dans le cas d'une modulation haute fréquence, comme illustré par l'exemple de la figure 13 avec $F_1$=-128°MHz

et $F_{OL}$=8192°MHz, le spectre brut en hyperfréquence en sortie du modulateur 21 a sensiblement la même allure que pour la modulation basse fréquence, mais il est beaucoup plus large.

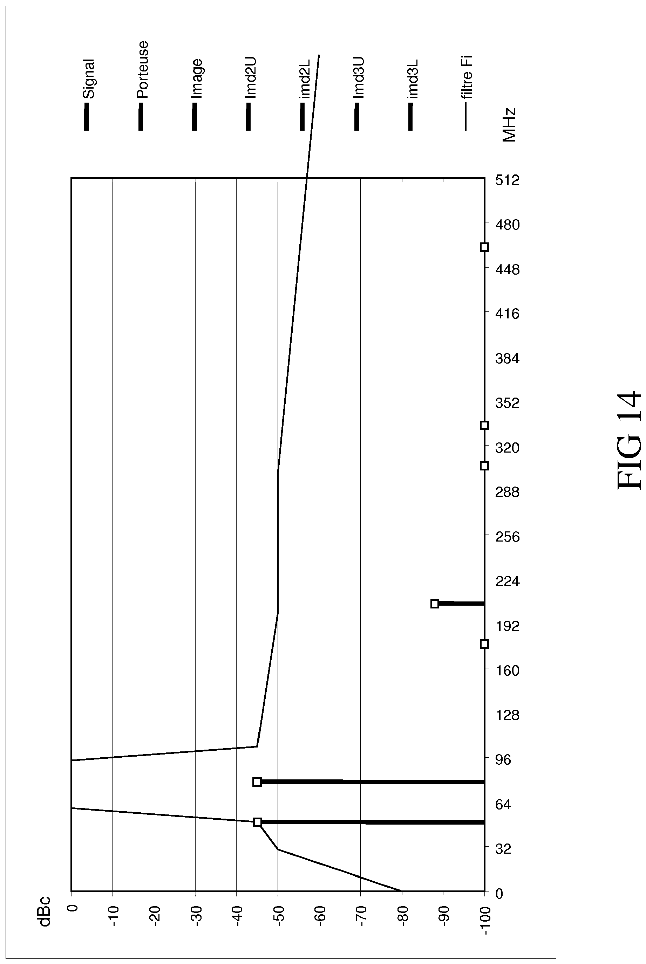

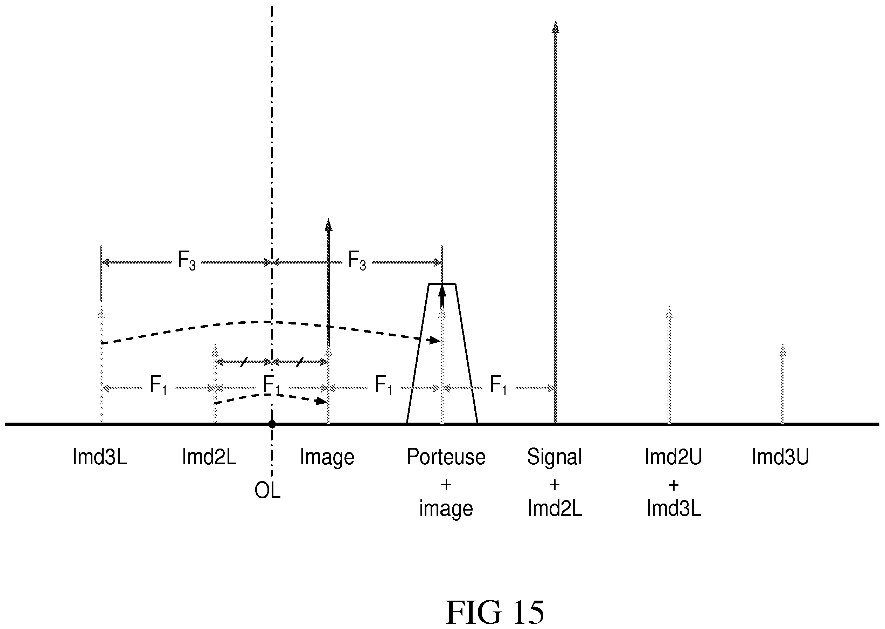

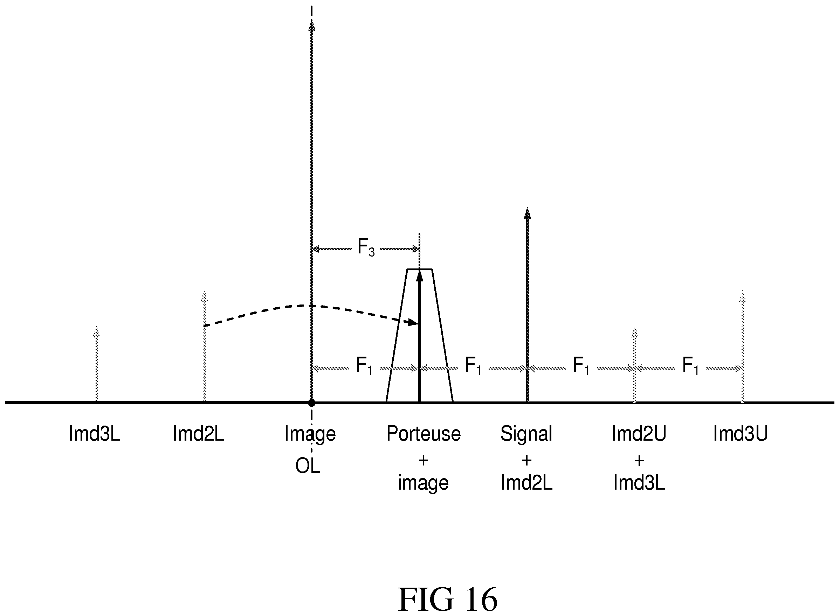

Comme illustré par la figure 14, qui illustre un exemple de spectre brut en fréquence intermédiaire avec $F_1$=-128°MHz, lorsque la largeur spectrale dépasse le double de la fréquence intermédiaire, le spectre se replie sur la bande utile. Dans certains cas particuliers, une raie indésirable se superpose exactement sur le signal sous test. Une coïncidence parfaite se produit quand $F_3 = \pm k \dfrac{F_1}{2}$, où $k \geq 1$. Dans la plupart des cas, le filtre anti-repliement atténue suffisamment le niveau du parasite hors bande et la mesure n'est pas perturbée. Lorsque le signal utile se replie exactement sur le parasite sous test, la protection du filtre analogique ne suffit pas et il faut décaler légèrement la fréquence $F_{OL}$ pour déplacer les fréquences et permettre au filtre numérique d'éliminer le gêneur. Les figures 15 et 16 illustrent des exemple de repliement sur la fréquence intermédiaire utile, dans les cas a et b respectivement.

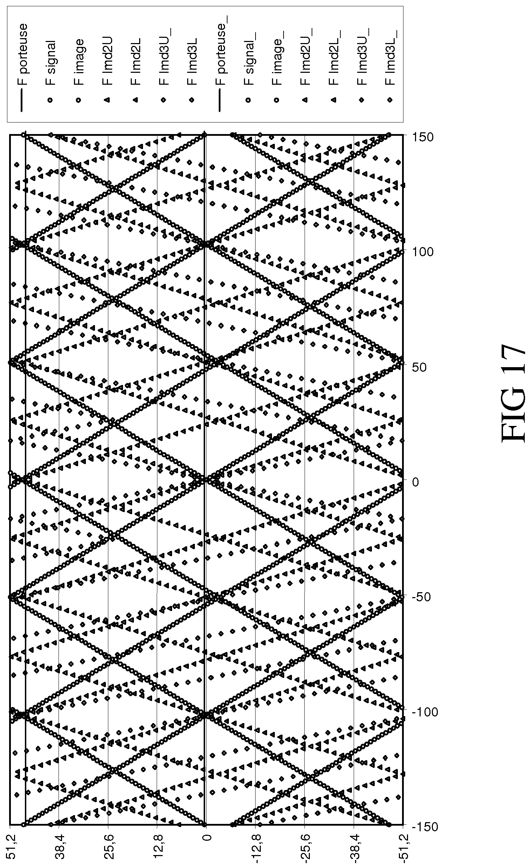

La figure 17 illustre le lieu des composantes spectrales en fonction de la fréquence de modulation. Le choix de fréquences proposé pour cet exemple permet avec une moyenne de 512 échantillons consécutifs, soit 5°µs, de corriger la fuite porteuse pour toutes les fréquences de la bande d'agilité au pas de 1 MHz.

**Annulation de la composante image**

***Modèle comportemental équivalent du modulateur vectoriel, relatif à l'image***

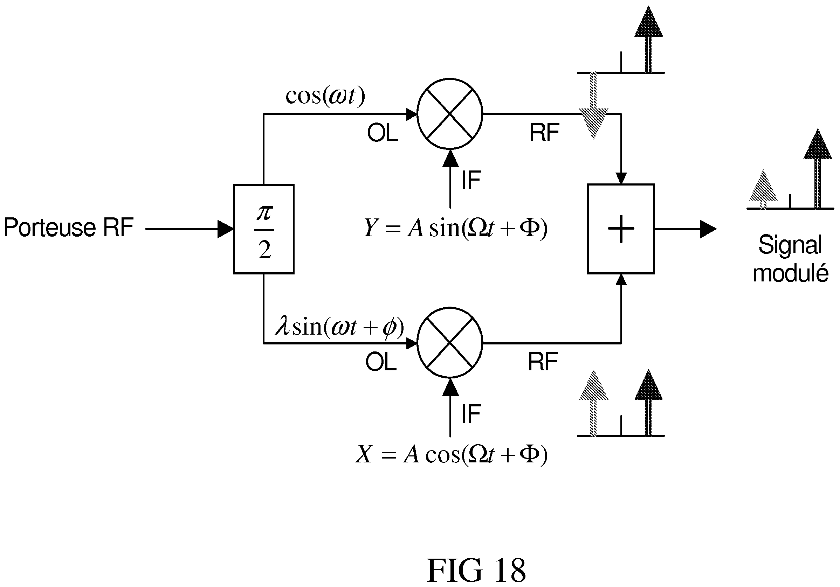

La figure 18 illustre par un synoptique un modèle comportemental équivalent au modulateur 21, ce modèle étant relatif à l'image. Le modulateur vectoriel 21 est, vis-à-vis du signal de modulation, utilisé en régime linéaire. On peut donc pour des fréquences OL et IF particulières regrouper arbitrairement l'ensemble des erreurs de gain et de phase au niveau d'une des branches OL du modèle comme indiqué sur la figure 18, en choisissant le plan de référence de phase approprié. Si on applique à ce modulateur imparfait un signal RF idéal, on obtient les relations suivantes :

$$s(t) = A\sin(\Omega t + \Phi)\cos(\omega t) + A\lambda \sin(\omega t + \phi)\cos(\Omega t + \Phi)$$

$$s(t) = A\sin(\Omega t + \Phi)\cos(\omega t) + A\lambda\left[\sin(\omega t)\cos(\phi) + \cos(\omega t)\sin(\phi)\right]\cos(\Omega t + \Phi)$$

$$s(t) = A\left\{ \begin{array}{l} \dfrac{\sin\left[(\Omega-\omega)t+\Phi\right]+\sin\left[(\Omega+\omega)t+\Phi\right]}{2} + \lambda\cos(\phi)\dfrac{\sin\left[(\omega-\Omega)t-\Phi\right]+\sin\left[(\omega+\Omega)t+\Phi\right]}{2} \\ + \lambda\sin(\phi)\dfrac{\cos\left[(\omega-\Omega)t-\Phi\right]+\cos\left[(\omega+\Omega)t+\Phi\right]}{2} \end{array} \right\}$$

Les déséquilibres de gain et de phase se traduisent donc par l'existence d'une composante image de pulsation $(\omega\text{-}\Omega)$ symétrique de la pulsation utile $(\omega\text{+}\Omega)$, telle que :

$$s(t) = \frac{A}{2}\left\{ \begin{array}{l} (\lambda\cos(\phi)-1)\,\sin\left[(\omega-\Omega)t-\Phi\right]+\lambda\sin(\phi)\,\cos\left[(\omega-\Omega)t-\Phi\right] \\ + (\lambda\cos(\phi)+1)\,\sin\left[(\Omega+\omega)t+\Phi\right]+\lambda\sin(\phi)\,\cos\left[(\omega+\Omega)t+\Phi\right] \end{array} \right\}$$

***Amplitude relative de l'image au signal utile***

Les modules de ces deux composantes symétriques s'écrivent donc respectivement :

$$A_-^2 = \left(\frac{A}{2}\right)^2 \left\{ \left[ (\lambda\cos(\phi)-1) \right]^2 + \left[ \lambda\sin(\phi) \right]^2 \right\}$$

$$= \left(\frac{A}{2}\right)^2 \left[ \lambda^2 - 2\lambda\cos(\phi) + 1 \right]$$

$$A_+^2 = \left(\frac{A}{2}\right)^2 \left\{ \left[ (\lambda\cos(\phi)+1) \right]^2 + \left[ \lambda\sin(\phi) \right]^2 \right\}$$

$$= \left(\frac{A}{2}\right)^2 \left[ \lambda^2 + 2\lambda\cos(\phi) + 1 \right]$$

On en déduit la formule classique du rapport d'amplitude entre l'image et le signal utile :

$$r = \frac{|image|}{|signal|} = \sqrt{\frac{1 - 2\lambda\cos(\phi) + \lambda^2}{1 + 2\lambda\cos(\phi) + \lambda^2}}$$

***Expression vectorielle de l'erreur de quadrature***

Dans le plan complexe (*Oxy*) associé à la modulation, il est intéressant d'associer aux défauts de quadrature un vecteur OM de module $\lambda$, phase $\phi$ proche du vecteur unitaire OI(1,0), et de choisir comme erreur le vecteur IM de module $\rho$ et de phase $\theta$ tels que :

$$\overrightarrow{OM} \begin{cases} \lambda\cos(\phi) \\ \lambda\sin(\phi) \end{cases} = \overrightarrow{OI} \begin{cases} 1 \\ 0 \end{cases} + \overrightarrow{IM} \begin{cases} e_x = \rho\cos(\theta) \\ e_y = \rho\sin(\theta) \end{cases}$$

Cette notation simplifie l'expression du rapport d'amplitude entre l'image et le signal utile, qui peut ainsi s'exprimer de la façon suivante :

$$r = \frac{\rho}{\sqrt{4 + 4\rho\cos(\theta) + \rho^2}} \cong \frac{\rho}{2} \quad (si\ \rho << 1)$$

De même, le signal modulé peut s'exprimer de la façon suivante :

$$s(t) = \frac{A}{2} \left\{ \begin{array}{l} \rho\cos(\theta)\ \ \sin[(\omega-\Omega)t - \Phi] + \rho\sin(\theta)\cos[(\omega-\Omega)t - \Phi] \\ [2+\rho\cos(\theta)]\sin[(\Omega+\omega)t + \Phi] + \rho\sin(\theta)\cos[(\omega+\Omega)t + \Phi] \end{array} \right\}$$

De même, la composante image peut s'exprimer de la façon suivante :

$$S_I(t) = \frac{A}{2} \begin{bmatrix} e_x \\ e_y \end{bmatrix} \exp\{ j[(\omega-\Omega)t - \Phi] \}$$

De même, la composante utile peut s'exprimer de la façon suivante :

$$S_U(t) = \frac{A}{2} \begin{bmatrix} 2 + e_x \\ e_y \end{bmatrix} \exp\{ j[(\omega + \Omega)t + \Phi] \}$$

*Matrice de distorsion*

Les défauts de quadrature de la modulation sont représentés par la matrice de passage du vecteur $\overrightarrow{OI} = \begin{bmatrix} 1 \\ 0 \end{bmatrix}$

au vecteur $\overrightarrow{OM} = \begin{bmatrix} 1 + e_x \\ e_y \end{bmatrix}$ que nous appelons « matrice de distorsion », par la relation suivante :

$$\begin{bmatrix} x \\ y \end{bmatrix} = \begin{bmatrix} 1 + e_x & 0 \\ e_y & 1 \end{bmatrix} \cdot \begin{bmatrix} X \\ Y \end{bmatrix} = \begin{bmatrix} d_{11} & 0 \\ d_{21} & 1 \end{bmatrix} \cdot \begin{bmatrix} X \\ Y \end{bmatrix}$$

Pour compenser la distorsion du modulateur imparfait, il suffit d'appliquer au signal modulant théorique (X, Y) l'opérateur de distorsion inverse pour obtenir la modulation compensée ($x_c$, $y_c$), comme indiqué par la relation suivante :

$$\begin{bmatrix} x_c \\ y_c \end{bmatrix} = \begin{bmatrix} d_{11} & 0 \\ d_{21} & 1 \end{bmatrix} \cdot \left( \begin{bmatrix} D_{11} = \dfrac{1}{d_{11}} & 0 \\ D_{21} = -\dfrac{d_{21}}{d_{11}} & 1 \end{bmatrix} \cdot \begin{bmatrix} X \\ Y \end{bmatrix} \right) = \begin{bmatrix} 1 & 0 \\ 0 & 1 \end{bmatrix} \cdot \begin{bmatrix} X \\ Y \end{bmatrix}$$

<div align="center">

distorsion     opérateur de     distorsion

initiale     distorsion inverse     corrigée

</div>

Les matrices de distorsion ont des propriétés intéressantes :

- le produit de deux matrices de distorsion est une matrice de distorsion ;
- l'inverse d'une matrice de distorsion est une matrice de distorsion ;
- une matrice quelconque se décompose de manière unique en un produit non commutatif d'une matrice de rotation par une matrice de distorsion :

$$\begin{bmatrix} a_{11} & a_{12} \\ a_{21} & a_{22} \end{bmatrix} = \begin{bmatrix} a_{22} & a_{12} \\ -a_{12} & a_{22} \end{bmatrix} \cdot \begin{bmatrix} \dfrac{a_{11}a_{22} - a_{12}a_{21}}{a_{12}^2 + a_{22}^2} & 0 \\ \dfrac{a_{12}a_{11} + a_{21}a_{22}}{a_{12}^2 + a_{22}^2} & 1 \end{bmatrix} = [R] \cdot [D]$$

- le choix de la branche de référence du modulateur qui porte les erreurs de gain et phase est arbitraire, il existe une variante duale de matrice de distorsion dont les coefficients sont en deuxième colonne. On peut aussi imaginer de répartir les erreurs symétriquement mais cela n'apporte pas de simplification ;
- en appliquant une nouvelle matrice de correction à un système partiellement corrigé on améliore la précision de la correction :

$$\begin{bmatrix} x \\ y \end{bmatrix} = \left( \begin{bmatrix} d_{11} & 0 \\ d_{21} & 1 \end{bmatrix} \cdot \begin{bmatrix} D_{11}^{(1)} & 0 \\ D_{21}^{(1)} & 1 \end{bmatrix} \right) \cdot \begin{bmatrix} D_{11}^{(2)} & 0 \\ D_{21}^{(2)} & 1 \end{bmatrix} \cdot \begin{bmatrix} X \\ Y \end{bmatrix}$$

$$\text{modulateur préréglé} \quad \text{nouvelle correction}$$

Du fait de la forme de la matrice, les règles du produit sont les suivantes :

$$\begin{cases} D_{11}^{(1)+(2)} = D_{11}^{(1)} D_{11}^{(2)} \\ D_{21}^{(1)+(2)} = D_{21}^{(1)} D_{11}^{(2)} + D_{21}^{(2)} \end{cases}$$

- l'implémentation matérielle du correcteur tient compte de la forme particulière des coefficients :

  ◦ $D_{11} = 1 + \varepsilon_1$ $D_{21} = \varepsilon_2$, les coefficients $\varepsilon_1$ et $\varepsilon_2$ sont d'autant plus petits que la quadrature est bonne ;
  ◦ la relation entre l'atténuation relative de l'image au signal est donnée par :

$$RdB = 20 \log_{10} \left[ \frac{\sqrt{\varepsilon_1^2 + \varepsilon_2^2}}{2} \right]$$

où $\varepsilon_{1,2}$ sont les coefficients de correction image ;
o la majorité des modulateurs en quadrature présentent une suppression naturelle d'image meilleure que 24.1 dBc. On majore l'erreur en supposant qu'elle ne porte sur un seul des deux termes :

$$-24.1\,dB = 20 \log_{10} \left[ \frac{\sqrt{\varepsilon^2}}{2} \right] = 20 \log_{10} \left[ \varepsilon_{max} \right] - 6.02\,dB \quad \Rightarrow |\varepsilon_{max}| = 10^{\frac{18.1}{20}} = 0.125$$

o la valeur décimale des coefficients d'erreur $\varepsilon_1$ et $\varepsilon_2$ est donc bornée en pratique par :

$$-\frac{1}{8} < \varepsilon_{1,2} < \frac{1}{8}$$

***Mesure vectorielle de l'image***

La mesure des composantes ($I_x$, $I_y$) de la raie image donne les termes ($e_x$, $e_y$) de l'erreur de modulation dans le repère de mesure. Comme pour la fuite porteuse, on établit la matrice de passage du repère de mesure au repère de commande en appliquant une perturbation connue sur les commandes de correction. Les corrections ($\varepsilon_x$, $\varepsilon_y$) sont déduites par inversion de la matrice de distorsion :

$$\varepsilon_x = D_{11} - 1 \quad = \frac{1}{d_{11}} - 1 \quad = \frac{1}{1 + e_1} - 1 \quad \cong -e_1$$

$$\varepsilon_y = D_{21} \quad = -\frac{d_{21}}{d_{11}} \quad = -e_2(1 + e_1) \quad \cong -e_2$$

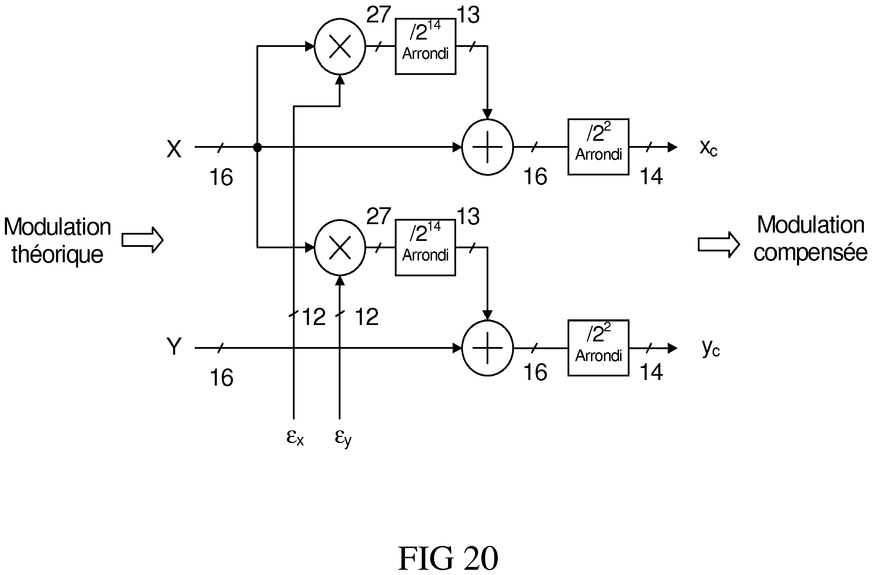

Lorsque les corrections sont petites, ce qui est toujours le cas en pratique, il suffit de prendre l'opposé des composantes de l'erreur vectorielle pour obtenir les coefficients de la matrice de distorsion inverse. Cette propriété permet de régler la quadrature en adoptant la même procédure que pour la fuite porteuse, en remplaçant l'application de tensions de décalage par l'application des coefficients de la matrice inverse de distorsion. La figure 20 illustre un exemple d'implémentation d'un correcteur de quadrature.

*Conditions de fréquence*

Le principe est le même que pour la mesure de la fuite porteuse, mais le décalage de l'oscillateur local est réglé pour centrer la raie image dans le filtre anti-repliement. Le rang non binaire de la multiplication, qui est de 44 dans le présent exemple, pour générer la fréquence OL nécessite de mettre en oeuvre une synthèse fractionnaire de sorte que la fréquence $F_3$ soit constante et qu'aucune erreur ne soit introduite par le filtre anti-repliement. Par exemple, avec une fréquence de modulation de 100 MHz, on trouve dans l'exemple de référence les fréquences suivantes :

$$F_{IMAGE} = 8192 - 100 \qquad = 8092 \, MHz$$

$$F_{OL} = \left( \frac{1821 + \dfrac{12}{44}}{8192} \times 819.2 \right) \times 44 \quad = 8013.6. \, MHz$$

$$F_3 = 8092 - 8013.6 \qquad = 78.4 \, MHz$$

On note que la fréquence OL est fractionnaire parce que le rang de multiplication $k_4 = 44$ dans notre exemple n'est pas une puissance de 2. Comme illustré par le tableau qui suit pour le présent exemple, un filtre qui calcule la moyenne de 512 points, soit un temps d'intégration de 5°µs, conserve la raie image et atténue complètement toutes les autres raies qui sont distribuées suivant des multiples entiers de 102.4/512 = 0.2 MHz pour toutes les fréquences de modulation au pas de 1 MHz :

| Composante | MHz | MHz |
|---|---|---|
| Porteuse | -2,4 | 50,4 |
| Signal | -4,8 | -49,6 |
| Image | 0 | 48 |
| Imd2U | -7,2 | -47,2 |
| imd2L | 45,6 | 2,4 |
| Imd3U | -9,6 | -44,8 |
| imd3L | 43,2 | 4,8 |

Lorsque l'écart entre la fréquence sous test et une raie perturbatrice du spectre vaut exactement un multiple de la fréquence d'échantillonnage, la fréquence sous test et la raie perturbatrice sont superposées, et la seule manière d'éviter l'ambiguïté. C'est ici le cas pour une modulation de 256 MHz, les fréquences étant les suivantes :

$$F_{IMAGE} = 8192 - 256 \qquad = 7936 \, MHz$$

$$F_{OL} = \left( \frac{1785 + \dfrac{36}{44}}{8192} \times 819.2 \right) \times 44 \quad = 7857.6. \, MHz$$

$$F_3 = 7936 - 7857.6 \qquad = 78.4 \, MHz$$

Comme l'écart entre la fréquence utile et l'image vaut $2 \times 256$ MHz = 512 MHz = $5 \times 102.4$ MHz, la fréquence utile se replie après échantillonnage exactement sur la raie image sous test, comme illustré dans le tableau suivant :

| Composante | MHz | MHz |
|---|---|---|
| Porteuse | -51,2 | -3,2 |
| Signal | 0 | 48 |
| Image | 0 | 48 |
| Imd2U | -51,2 | -3,2 |
| imd2L | -3,2 | -51,2 |
| Imd3U | 0 | 48 |
| imd3L | 48 | 0 |

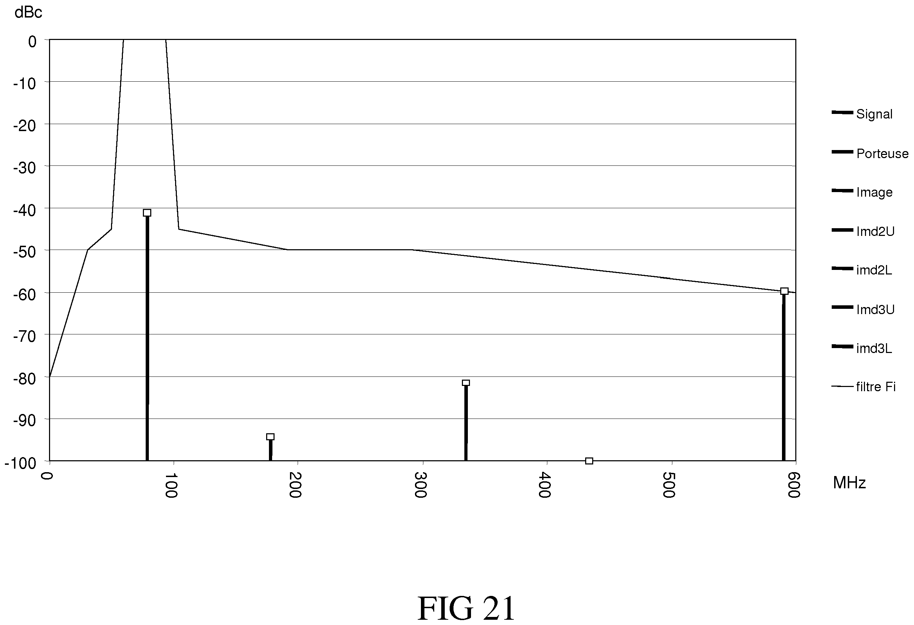

Comme il est difficile de changer la fréquence d'échantillonnage qui conditionne les traitements, la seule protection est le filtre anti-repliement. Il peut donc être intéressant le cas échéant d'ajouter un filtre passe-bas ou « stop-bande » d'appoint pour atténuer la fréquence gênante qui est ici de 78.4 + 512 = 590.4 MHz. La figure 21 illustre par un spectre en fréquence intermédiaire, avec $F_1=256°$MHz, $F_{OL}=7857.6°$MHz et $F_3=78.4°$MHz, les fréquences associées à la mesure de la raie image pour $F_1=100°$MHz.

**Annulation des composantes produites par les non-linéarités d'ordre 2 et 3**

Les raies parasites concernées résultent de non-linéarités d'ordre 2 et 3. Le principe de la compensation est d'ajouter au signal de modulation des harmoniques 2 et 3 asservies en opposition de phase des parasites, comme pour la composante image.

***Matrice de compensation et composantes cartésiennes***

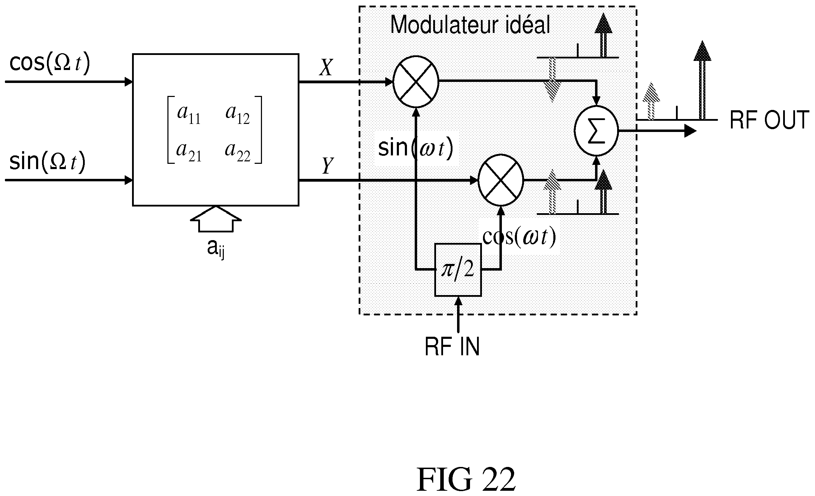

La figure 22 illustre par une synoptique un modulateur virtuel idéal modulé par un signal monochromatique pur, dont les composantes cartésiennes ont subi une transformation par une matrice [A] arbitraire selon la relation suivante :

$$\begin{bmatrix} X \\ Y \end{bmatrix} = \begin{bmatrix} a_{11} & a_{12} \\ a_{21} & a_{22} \end{bmatrix} \begin{bmatrix} \cos(\Omega\,t) \\ \sin(\Omega\,t) \end{bmatrix}$$

Le signal modulé s'écrit :

$$S(t) = X\,\sin(\omega\,t) + Y\,\cos(\omega\,t)$$
$$= \left[a_{11}\cos(\Omega\,t) + a_{12}\sin(\Omega\,t)\right]\sin(\omega\,t) + \left[a_{21}\cos(\Omega\,t) + a_{22}\sin(\Omega\,t)\right]\cos(\omega\,t)$$
$$= a_{11}\cos(\Omega\,t)\sin(\omega\,t) + a_{12}\sin(\Omega\,t)\sin(\omega\,t) + a_{21}\cos(\Omega\,t)\cos(\omega\,t) + a_{22}\sin(\Omega\,t)\cos(\omega\,t)$$

En remplaçant les produits trigonométriques par des sommes, il vient :

$$S(t) = \frac{a_{11}}{2}\sin(\omega\,t + \Omega\,t) + \frac{a_{11}}{2}\sin(\omega\,t - \Omega\,t) - \frac{a_{12}}{2}\cos(\omega\,t + \Omega\,t) + \frac{a_{12}}{2}\cos(\omega\,t - \Omega\,t)$$
$$+ \frac{a_{21}}{2}\cos(\omega\,t + \Omega\,t) + \frac{a_{21}}{2}\cos(\omega\,t - \Omega\,t) + \frac{a_{22}}{2}\sin(\omega\,t + \Omega\,t) - \frac{a_{22}}{2}\sin(\omega\,t - \Omega\,t)$$

Soit, en regroupant les termes associés aux fréquences somme et différence :

$$S(t) = \left(\frac{a_{12} + a_{21}}{2}\right)\cos(\omega t - \Omega t) + \left(\frac{a_{11} - a_{22}}{2}\right)\sin(\omega t - \Omega t)$$

$$+ \left(\frac{a_{21} - a_{12}}{2}\right)\cos(\omega t + \Omega t) + \left(\frac{a_{11} + a_{22}}{2}\right)\sin(\omega t + \Omega t)$$

La transformation de coordonnées permet donc de contrôler simultanément deux composantes spectrales symétriques, d'amplitude et de phase arbitraires, ce qui donne le moyen de compenser une paire de raies produites par non-linéarité au moyen des coefficients de la matrice [A].

*Principe du correcteur de distorsion*

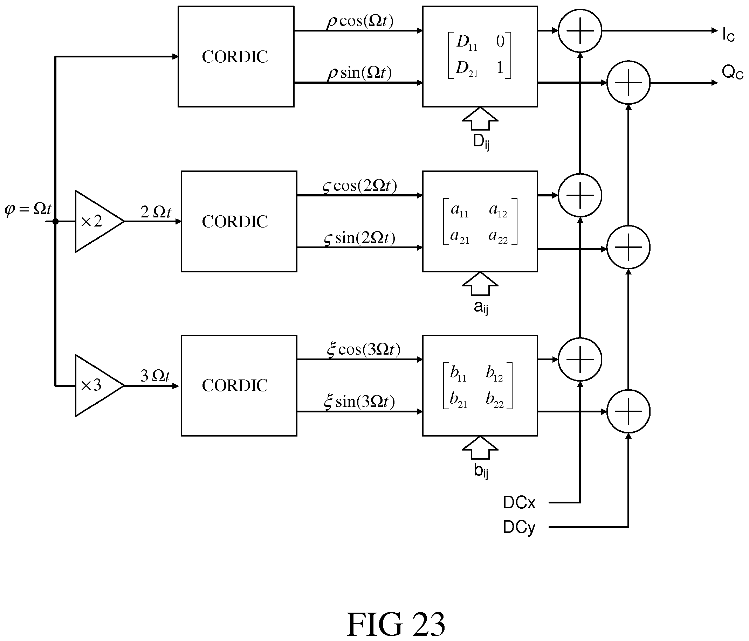

La figure 23 illustre les principes d'un correcteur de distorsion. Le correcteur calcule la phase du signal de correction en multipliant la phase du signal utile par le rang (2 ou 3) qui correspond à l'harmonique à supprimer, et applique une transformation matricielle afin de générer deux composantes de fréquences symétriques qui s'ajoutent vectoriellement aux raies parasites créées involontairement par distorsion harmonique. En pratique, le niveau de modulation est réglé pour que l'amplitude des raies parasites crées par inter modulation d'ordre 2 et 3 soit inférieure à -48 dBc. Ceci permet d'économiser 8 bits sur le format des données du CORDIC (« COordinate Rotation DIgital Computer ») et des matrices de correction d'ordre 2 et 3.

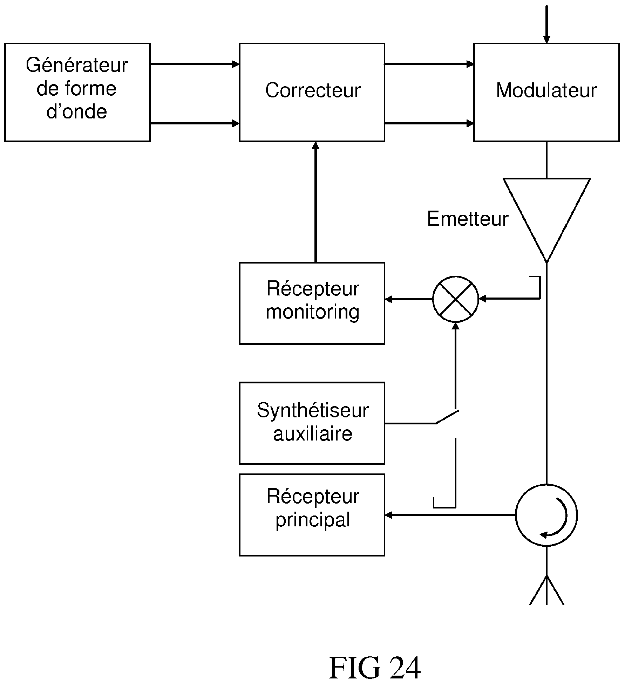

La méthode de correction par démodulation synchrone et par asservissement cartésien des composantes parasites décrite précédemment permet de bénéficier de la précision de la démodulation numérique, ce qui améliore les performances de qualité spectrale dans une large bande de modulation, et permet de bénéficier d'une meilleure tolérance aux perturbations de l'environnement. L'invention permet de synthétiser des signaux sinus de fréquence agile très purs dans une large bande instantanée, l'étalonnage pouvant être effectué pendant l'utilisation. Les coefficients de correction sont entretenus en mémoire de manière à être disponibles immédiatement après un saut de fréquence ou pour la génération d'une forme d'onde différente, par exemple une rampe de fréquence. Les fonctions de surveillance et d'auto étalonnage peuvent ainsi être étendues dans une application de type radar, comme l'exemple illustré par la figure 24. La fonction de surveillance y peut être organisée de manière à surveiller la puissance et la qualité du signal prélevé après un émetteur, afin de corriger les défauts d'un amplificateur en agissant sur le signal complexe modulant.

**Revendications**

1. Procédé d'annulation de composantes spectrales parasites comprenant la fuite porteuse, la raie image et au moins une autre raie d'intermodulation d'un signal analogique généré par un dispositif permettant de moduler un signal analogique à partir d'un signal numérique de modulation, le dispositif comportant un générateurs de forme d'onde (2) et un récepteur de surveillance (22) dans une boucle fermée d'asservissement, le récepteur de surveillance comportant des oscillateurs numériques (DDS_2, DDS_3) et une PLL (15) multipliant la fréquence associé a un oscillateur numérique (DDS_2) par un coefficient multiplicatif entier pour permettre une démodulation cohérente sans glissement de phase du signal analogique modulé (RF_OUT) produit par le dispositif, le signal numérique de modulation étant asservi sur le signal analogique de manière à annuler des composantes parasites présentes dans le signal analogique, le procédé comportant:

   - une phase de synchronisation des oscillateurs numériques (DDS_2, DDS_3) du récepteur de surveillance;

   le procédé comportant pour chaque composante spectrale parasite:

   - une phase de synchronisation de la phase du générateur de forme d'onde(2) et de la phase du récepteur de surveillance (22), de sorte a définir une matrice de compensation ($D_{ij}$, $a_{ij}$, $b_{ij}$) entre un plan cartésien associé à la mesure et un plan cartésien associe a la modulation ;
   - une phase de mesure vectorielle des composantes spectrales parasites dans le plan cartésien associé à la mesure à l'aide du multiplicateur de fréquence associé à l'oscillateur numérique (DDS_2) ;
   - Une phase d'établissement des coefficients de la matrice de compensation destinée à annuler la composante spectrale parasite, lesdits coefficients étant dérivés des composantes spectrales parasites mesurées dans le plan cartésien associé à la mesure;
   - Une phase de compensation consistant a multiplier la fréquence $\Omega$ du signal de modulation ou une harmonique de la fréquence Ω par la matrice de compensation déterminée pour chaque composante parasite ($D_{ij}$, $a_{ij}$, $b_{ij}$).

2. Procédé selon la revendication 1, **caractérisé en ce que** la phase de mesure des composantes spectrales parasites utilise des filtres capables de discriminer les différentes composantes spectrales dans le signal analogique modulé, sans interférer avec les raies parasites générées par le dispositif utilisé pour réaliser la mesure.

3. Procédé selon la revendication 2, **caractérisé en ce que** les filtres mis en oeuvre combinent un plan de fréquences à des filtres à moyenne glissante, les filtres à moyenne glissante étant optimaux en bruit et ayant leurs zéros de transmission distribués de manière régulière dans le plan de fréquences, de sorte que les composantes parasites sont placées sur les zéros de puissance.

4. Procédé selon la revendication 1, **caractérisé en ce que** les composantes parasites incluent:

- une fuite porteuse, et/ou ;
- une raie image, et/ou ;
- des raies d'intermodulation d'ordre 2, et/ou ;
- des raies d'intermodulation d'ordre 3.

**Patentansprüche**

1. Verfahren zum Beheben von parasitären Spektralkomponenten, die Trägerverlust, den Bildstrahl und wenigstens einen anderen Intermodulationsstrahl eines analogen Signals umfassen, erzeugt durch eine Vorrichtung, die das Modulieren eines analogen Signals auf der Basis eines digitalen Modulationssignals zulässt, wobei die Vorrichtung einen Wellenformgenerator (2) und einen Überwachungsempfänger (22) in einem geschlossenen Regelkreis umfasst, wobei der Überwachungsempfänger digitale Oszillatoren (DDS_2, DDS_3) und eine PLL (15) umfasst, die die mit einem digitalen Oszillator (DDS_2) assoziierte Frequenz mit einem ganzzahligen Multiplikationskoeffizienten multipliziert, um eine kohärente Demodulation ohne Phasenverschiebung des modulierten Analogsignals (RF_OUT) zuzulassen, produziert durch die Vorrichtung, wobei das digitale Modulationssignal auf dem analogen Signal so reguliert wird, dass in dem analogen Signal vorhandene parasitäre Komponenten aufgehoben werden, wobei das Verfahren Folgendes beinhaltet:

- eine Phase des Synchronisierens der digitalen Oszillatoren (DDS_2, DDS_3) des Überwachungsempfängers;

wobei das Verfahren für jede parasitäre Spektralkomponente Folgendes beinhaltet:

- eine Phase des Synchronisierens der Phase des Wellenformgenerators (2) und der Phase des Überwachungsempfängers (22), um eine Kompensationsmatrix ($D_{ij}$, $a_{ij}$, $b_{ij}$) zwischen einer mit dem Messwert assoziierten kartesischen Ebene und einer mit der Modulation assoziierten kartesischen Ebene zu definieren;
- eine Phase des vektoriellen Messens von parasitären Spektralkomponenten in der mit der Messung assoziierten kartesischen Ebene mit Hilfe des mit dem digitalen Oszillator (DDS_2) assoziierten Frequenzmultiplikators;
- eine Phase des Einrichtens von Koeffizienten der Kompensationsmatrix zum Aufheben der parasitären Spektralkomponente, wobei die Koeffizienten von den in der mit der Messung assoziierten kartesischen Ebene gemessenen parasitären Spektralkomponenten abgeleitet sind;
- eine Phase des Kompensierens, bestehend aus dem Multiplizieren der Frequenz Ω des Modulationssignals oder einer Harmonischen der Frequenz Ω mit der für jede parasitäre Komponente ($D_{ij}$, $a_{ij}$, $b_{ij}$) bestimmten Kompensationsmatrix.

2. Verfahren nach Anspruch 1, **dadurch gekennzeichnet, dass** die Phase des Messens der parasitären Spektralkomponenten Filter benutzt, die zwischen den unterschiedlichen Spektralkomponenten in dem modulierten analogen Signal unterscheiden können, ohne die parasitären Strahlen zu stören, die von der zum Realisieren der Messung benutzten Vorrichtung erzeugt werden.

3. Verfahren nach Anspruch 2, **dadurch gekennzeichnet, dass** die implementierten Filter eine Ebene von Frequenzen mit gleitenden Mittelwertfiltern kombinieren, wobei die gleitenden Mittelwertfilter rauschoptimiert sind und ihre Übertragungsnullen gleichmäßig in der Frequenzebene verteilt sind, so dass die parasitären Komponenten auf den Leistungsnullen platziert sind.

**4.** Verfahren nach Anspruch 1, **dadurch gekennzeichnet, dass** die parasitären Komponenten Folgendes beinhalten:

- einen Trägerverlust und/oder
- einen Bildstrahl und/oder
- Intermodulationsstrahlen der Ordnung 2, und/oder
- Intermodulationsstrahlen der Ordnung 3.


**Claims**

**1.** Method of cancelling spurious spectral components including the carrier leak, the image distortion and at least one other intermodulation distortion of an analogue signal generated by a device that makes it possible to modulate an analogue signal from a digital modulation signal, the device comprising a waveform generator (2) and a monitoring receiver (22) in a closed servo loop, the monitoring receiver comprising digital oscillators (DDS_2, DDS_3) and a PLL (15) multiplying the frequency associated with a digital oscillator (DDS_2) by an integer multiplier coefficient so as to allow coherent demodulation without phase shift of the modulated analogue signal (RF_OUT) produced by the device, the digital modulation signal being locked on the analogue signal so as to cancel spurious components present in the analogue signal, the method comprising:

- a step of synchronizing digital oscillators (DDS_2, DDS_3) of the monitoring receiver (22);

the method comprising for each spurious spectral component:

- a step of synchronizing the phase of the waveform generator (2) and the phase of the monitoring receiver (22), so as to define a compensation matrix ($D_{ij}$, $a_{ij}$, $b_{ij}$) between a Cartesian plane associated with the measurement and a Cartesian plane associated with the modulation;
- a step of measuring vectorially the spurious spectral components in the Cartesian plane associated with the measurement with the aid of the frequency multiplier associated with the digital oscillator (DDS_2);
- a step of establishing the coefficients of the compensation matrix intended to cancel the spurious spectral component, said coefficients being derived from the spurious spectral components measured in the Cartesian plane associated with the measurement;
- a step of compensating consisting of multiplying the frequency $\Omega$ of the modulation signal or a frequency harmonic $\Omega$ by the compensation matrix determined for each spurious component ($D_{ij}$, $a_{ij}$, $b_{ij}$).

**2.** The method according to Claim 1, **characterized in that** the step of measuring the spurious spectral components uses filters capable of discriminating the different spectral components in the modulated analogue signal without interfering with the spurious distortions generated by the device used to perform the measurement.

**3.** The method according to Claim 2, **characterized in that** the implemented filters combine a frequency plan with moving-average filters, the moving-average filters being optimal noise-wise and having their transmission zeros distributed evenly in the frequency plan, so that the spurious components are placed on the zeros of power.

**4.** The method according to Claim 1, **characterized in that** the spurious components include:

- a carrier leak, and/or;
- an image distortion, and/or;
- $2^{nd}$-order intermodulation distortions; and/or
- $3^{rd}$-order intermodulation distortions.

FIG 1

Composante
utile

Fuite
Porteuse

Image

IMD3L IMD2L

IMD2U IMD3U

$F_0 - 2 F_m$  $F_0 - F_m$  $F_0$  $F_0 + F_m$  $F_0 + 3 F_m$

Q

I

Trajectoire idéale

Trajectoire
réelle

FIG 2

FIG 3

EP 2 114 045 B1

FIG 4

EP 2 114 045 B1

-2 Fech    -Fech    0    Fech    2 fech

| -4 | -3 | -2 | -1 | 0 | 1 | 2 | 3 |

-3 Fech/2    - Fech/2    Fech/2    3 Fech/2

FIG 5

FIG 6

FIG 7

FIG 8

FIG 9

EP 2 114 045 B1

FIG 10

FIG 11

Filtres à moyenne glissante N pair

FIG 12

EP 2 114 045 B1

FIG 13

dBc

Signal

Porteuse

Image

Imd2U

imd2L

Imd3U

imd3L

filtre Fi

MHz

FIG 14

FIG 15

FIG 16

EP 2 114 045 B1

**FIG 17**

$\cos(\omega t)$

OL

IF

$Y = A\sin(\Omega t + \Phi)$

RF

Porteuse RF

$\dfrac{\pi}{2}$

+

Signal modulé

$\lambda\sin(\omega t + \phi)$

OL

IF

$X = A\cos(\Omega t + \Phi)$

RF

FIG 18

EP 2 114 045 B1

EP 2 114 045 B1

FIG 19

FIG 20

EP 2 114 045 B1

FIG 21

FIG 22

FIG 23

FIG 24

**EP 2 114 045 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6931343 B2
- US 20060062324 A1
- US 2004136470 A1